# EUROPÄISCHE PATENTSCHRIFT

(11) **EP 4 416 554 B1**
(45) Veröffentlichungstag und Bekanntmachung des Hinweises auf die Patenterteilung: **04.11.2026**
(21) Anmeldenummer: 22777986.5
(22) Anmeldetag: 21.09.2022
(51) Int. Cl.: G03F 7/00, G02B 26/08, G02B 5/08

(54) **MEHRFACHSPIEGELANORDNUNG**
MULTI-MIRROR ARRAY
RÉSEAU À MIROIRS MULTIPLES

(30) Priorität: 14.10.2021 DE 102021211619
(43) Veröffentlichungstag der Anmeldung: 21.08.2024
(73) Patentinhaber: Carl Zeiss SMT GmbH, 73447 Oberkochen (DE)
(72) Erfinder: BECKER, Moritz, 73430 Aalen (DE); SAROV, Yanko, 73431 Aalen (DE); DINGER, Udo, 73447 Oberkochen (DE); EHM, Dirk, 66701 Beckingen (DE); HAACKER, Fabian, 73434 Aalen (DE); SCHMIDT, Stefan Wolfgang, 66693 Mettlach (DE); SCHÖLL, Achim, 97318 Kitzingen (DE)
(74) Vertreter: Patentanwälte Ruff, Wilhelm, Beier, Dauster & Partner mbB
(86) Internationale Anmeldenummer: PCT/EP2022/076274
(87) Internationale Veröffentlichungsnummer: WO 2023/061713

(56) Entgegenhaltungen:
- DE-A1- 102019 214 269
- US-A1- 2011 146 663
- US-A1- 2014 218 708

## Beschreibung

### ANWENDUNGSGEBIET UND STAND DER TECHNIK

Die Erfindung betrifft eine Mehrfachspiegelanordnung gemäß dem Oberbegriff von Anspruch 1 sowie ein Beleuchtungssystem für eine Anlage, die mindestens eine solche Mehrfachspiegelanordnung aufweist. Ein bevorzugtes Anwendungsgebiet liegt im Bereich von EUV-Anlagen, also Anlagen, die Arbeitswellenlängen aus dem extremen Ultraviolettbereich (EUV) verwenden.

Zur Herstellung von Halbleiterbauelementen und anderen feinstrukturierten Bauteilen werden heutzutage überwiegend mikrolithographische Projektionsbelichtungsverfahren eingesetzt. Dabei werden Masken (Retikel) oder andere Mustererzeugungseinrichtungen verwendet, die das Muster einer abzubildenden Struktur tragen oder bilden, z.B. ein Linienmuster einer Schicht (Layer) eines Halbleiterbauelementes. Das Muster wird mit Hilfe eines Beleuchtungssystems beleuchtet, welches aus der Strahlung einer primären Strahlungsquelle eine auf Muster gerichtete Beleuchtungsstrahlung formt, die durch bestimmte Beleuchtungsparameter gekennzeichnet ist und innerhalb eines Beleuchtungsfeldes definierter Form und Größe auf das Muster auftrifft. Die durch das Muster veränderte Strahlung läuft durch ein Projektionsobjektiv, welches das Muster auf das zu belichtende, mit einer strahlungsempfindlichen Schicht beschichtete Substrat abbildet.

Viele aktuelle mikrolithographische Projektionsbelichtungsverfahren und -anlagen nutzen Strahlung aus dem relativ kurzwelligen Teil des Ultraviolettbereichs (UV-Bereich), insbesondere Strahlung mit Wellenlängen von weniger als 260 nm. Dazu gehören u.a. Systeme mit Arbeitswellenlängen aus dem tiefen Ultraviolettbereich (DUV), die z.B. bei ca. 248 nm oder ca. 193 nm liegen und zur Erzeugung viele mittelkritische Strukturen genutzt werden können. Gelegentlich wird der Wellenlängenbereich unterhalb ca. 200 nm bis hinunter zum EUV-Bereich auch als Vakuumultraviolettbereich (VUV) bezeichnet.

Um immer feinere Strukturen erzeugen zu können, wurden in den letzten Jahren optische Systeme entwickelt, die hohe Auflösungsvermögen im Wesentlichen durch die kurze Wellenlänge der verwendeten elektromagnetischen Strahlung aus dem extremen Ultraviolettbereich (EUV) erzielen, insbesondere mit Arbeitswellenlängen im Bereich zwischen 5 nm und 30 nm. EUV-Strahlung kann nicht mit Hilfe refraktiver optischer Elemente fokussiert oder geführt werden, da die kurzen Wellenlängen von den bekannten, bei höheren Wellenlängen transparenten optischen Materialien absorbiert werden. Daher werden in EUV-Anlagen z.B. für die EUV-Lithographie Spiegelsysteme eingesetzt.

In der Regel werden je nach Art der abzubildenden Strukturen unterschiedliche Beleuchtungsmodi (sogenannte Beleuchtungssettings) verwendet, die durch unterschiedliche örtliche Intensitätsverteilung der Beleuchtungsstrahlung in einer Pupillenebene des Beleuchtungssystems charakterisiert werden können. Um diese flexibel einstellen zu können hat ein Beleuchtungssystem eine Pupillenformungseinheit zum Empfang von Strahlung der primären Strahlungsquelle und zur Erzeugung einer variabel einstellbaren zweidimensionalen Intensitätsverteilung in der Pupillenfläche des Beleuchtungssystems.

Einige Konzepte sehen vor, in der Pupillenformungseinheit wenigstens eine steuerbare Mehrfachspiegelanordnung (Multi-Mirror-Array, MMA) einzusetzen, die eine Vielzahl einzelner Spiegelelemente aufweist, die von einer gemeinsamen Trägerstruktur getragen werden und die unabhängig voneinander verkippt werden können, um die Winkelverteilung der auf die Gesamtheit der Spiegelelemente fallenden Strahlung gezielt so zu verändern, dass sich in der Pupillenebene die gewünschte räumliche Beleuchtungsintensitätsverteilung ergibt. Die Spiegelflächen sind im wesentlichen flächenfüllend angeordnet. Zwischen unmittelbar benachbarten Spiegelelementen verbleibt ein durch Spiegelsubstrat-Seitenflächen begrenzter Spalt zur Sicherstellung einer kollisionsfreien Relativbewegung der Spiegelelemente. Solche Mehrfachspiegelanordnungen werden häufig auch als Facettenspiegel bezeichnet, die spiegelnden Vorderseiten der Spiegelelemente bilden die Facetten.

Um die geometrischen Reflexionseigenschaften einer steuerbaren Mehrfachspiegelanordnung gezielt einstellen zu können, hat diese in der Regel für jedes Spiegelelement ein mit dem Spiegelelement gekoppeltes Aktuatorsystem zur steuerbaren Veränderung der Lage des Spiegelelements relativ zu der die Spiegelelemente tragenden Trägerstruktur. Die Steuerung von Stellbewegungen des Aktuatorsystems erfolgt über eine der Mehrfachspiegelanordnung zugeordnete Steuereinheit. Unter der Kontrolle der Steuereinrichtung kann die Orientierung der Spiegelfläche des Spiegelelements ausgehend von der Nullstellung gezielt verändert werden.

Häufig wird angestrebt, die individuell einstellbaren Spiegelflächen immer weiter zu verkleinern, um die geometrisch-optischen Reflexionseigenschaften des MMA mit hoher örtlicher Auflösung einstellen zu können. Zur Herstellung werden dann vielfach Technologien aus dem Bereich der Herstellung Mikro-Elektro-Mechanischer-Systeme (kurz: MEMS) genutzt, um Antriebselemente, Sensorelemente und Mechanikelemente als MEMS-Strukturen im Bereich zwischen der Spiegelfläche und der Trägerstruktur zu erzeugen.

Die US 2017/363861 A1 (entsprechend DE 10 2015 204 874 A1) beschreibt eine Verlagerungs-Einrichtung zur Verschwenkung eines mit MEMS-Technik hergestellten Spiegel-Elements mit zwei Schwenk-Freiheitsgraden. Diese umfasst eine Elektrodenstruktur mit Aktuator-Elektroden, die als Kammelektroden ausgebildet sind, welche in einer einzigen Ebene angeordnet sind und einen Direktantrieb zur Verschwenkung des Spiegel-Elements bilden. Andere Beispiele für MMAs mit MEMS-Spiegelelementen sind z.B. in US 10,261,424 B2, der DE 10 2013 201 509 A1 oder der WO 2021/032483 A1 offenbart.

Der Betrieb einer EUV-Anlage mit energiereicher EUV-Strahlung kann zu prinzipbedingten Degradationserscheinungen in der EUV-Anlage führen. Die WO 2017/072195A1 (entsprechend DE 10 2015 221 209 A1) beschreibt, dass z.B. kontaminierende Stoffe in einer EUV-Lichtquelle erzeugt werden, bei der Zinn-Tröpfchen zur Erzeugung der EUV-Strahlung verwendet werden. Diese werden mit einem Laserstrahl in einen Plasma-Zustand überführt, wodurch die Zinn-Tröpfchen teilweise evaporieren und Zinn-Partikel entstehen, die sich in der EUV-Lithographieanlage ausbreiten und entweder direkt oder in Form einer Zinn-Schicht an der optischen Oberfläche von optischen Elementen beispielsweise im Beleuchtungssystem oder im Projektionssystem sowie an mechanischen bzw. mechatronischen Bauelementen der EUV-Lithographieanlage anlagern. Zinn-Kontaminationen können auch durch Ausgasungseffekte an mit Zinn kontaminierten Komponenten in der EUV-Lithographieanlage entstehen, die durch in der EUV-Lithographieanlage vorhandenen Wasserstoff bzw. ein Wasserstoff-Plasma hervorgerufen werden. Zum Schutz der Einzelspiegel eines mithilfe von MEMS-Techniken hergestellten MMA wird ein Schutzelement beschrieben, das eine Membran aufweist, die von einem gitterartig aufgebauten Rahmen getragen wird und durch mehrere Membransegmente gebildet ist, die jeweils einen Teilbereich der Oberfläche des MMA, z.B. eine Gruppe benachbarter Spiegelelemente, vor den kontaminieren Stoffen schützen. Die vom Rahmen getragene Membran wird mit Abstand vor den Spiegelflächen angeordnet.

Die DE 10 2016 206 202 A1 beschreibt eine optische Baugruppe mit einer Mehrfachspiegelanordnung. Um Kontaminationen der Spiegelelemente mit aus der EUV-Strahlungsquelle stammenden Zinn-Partikeln und anderen kontaminierenden Stoffe zu vermeiden, weist die optische Baugruppe eine Spüleinrichtung zur Erzeugung eines Spülgasstroms auf, der durch einen Spalt zwischen den Spiegelkörpern von mindestens zwei benachbarten Einzelspiegeln verläuft, wobei der Spülgasstrom von einer der Tragstruktur zugewandten zweiten Seite der Spiegelkörper in Richtung auf die Strahlungseintrittsseite der Spiegelkörper ausgerichtet ist.

Dokument US 2014/0218708 A1 offenbart Mehrfachspiegelanordnungen mit individuell verkippbaren Spiegelelementen. Zwischen unmittelbar benachbarten Spiegelelementen befindet sich jeweils ein durch Seitenflächen der angrenzenden Spiegelsubstrate begrenzter Spalt, um eine kollisionsfreie Relativbewegung der benachbarten Spiegelelemente gegeneinander zu ermöglichen. Zum Schutz von hinter den Spiegelflächen liegenden Komponenten der Mehrfachspiegelanordnung gegen strahlungsbedingte Schäden (Aufheizung, strahlungsinduzierte Degradation) werden verschiedene Maßnahmen vorgeschlagen, mit denen verhindert werden soll, dass eintreffendes Licht durch die Spalte hindurch in den Bereich hinter die Spiegelflächen gelangen kann.

### AUFGABE UND LÖSUNG

Vor diesem Hintergrund liegt der Erfindung die Aufgabe zugrunde, eine Mehrfachspiegelanordnung bereitzustellen, die bei Verwendung in einer mit relativ kurzwelliger Strahlung aus dem Ultraviolettbereich arbeitenden Anlage über längere Zeiträume unter dem Einfluss von kurzwelliger UV-Strahlung funktionsfähig bleibt.

Zur Lösung dieser Aufgabe stellt die Erfindung eine Mehrfachspiegelanordnung mit den Merkmalen von Anspruch 1 sowie ein Beleuchtungssystem mit den Merkmalen von Anspruch 15 bereit. Vorteilhafte Weiterbildungen sind in den abhängigen Ansprüchen angegeben. Der Wortlaut sämtlicher Ansprüche wird durch Bezugnahme zum Inhalt der Beschreibung gemacht. Eine Mehrfachspiegelanordnung gemäß der beanspruchten Erfindung weist eine Trägerstruktur und eine Vielzahl von Spiegeleinheiten auf, die an der Trägerstruktur in einer Rasteranordnung nebeneinander angeordnet sind. Jede der Spiegeleinheiten weist ein Basiselement und ein gegenüber dem Basiselement individuell beweglich gelagertes Spiegelelement auf. Ein Spiegelelement weist ein Spiegelsubstrat auf, das an einer dem Basiselement abgewandten Vorderfläche eine Reflexionsbeschichtung zur Bildung einer die verwendete Strahlung gut reflektierenden Spiegelfläche trägt. Jedes Spiegelsubstrat weist weiterhin eine dem Basiselement zugewandte Rückfläche und an seinem Umfang Seitenflächen auf. Die Anordnung der Spiegelelemente ist konstruktiv so ausgelegt, dass eine Relativbewegung der Spiegelelemente zueinander im kompletten spezifizierten Bewegungsbereich (range) der Spiegelelemente ohne gegenseitige Kollision erfolgt, so dass eine gegenseitige Berührung der Spiegelelemente konstruktiv ausgeschlossen ist.

Die Spiegelflächen der Mehrfachspiegelanordnung sind im Wesentlichen flächenfüllend nebeneinander angeordnet. Sie bilden dadurch eine reflektive Gesamtfläche, die wesentlich größer ist als die einzelnen Spiegelflächen. Die Gesamtfläche ist jedoch nicht völlig lückenlos reflektierend. Vielmehr liegt zwischen unmittelbar benachbarten Spiegelelementen ein durch Seitenflächen der angrenzenden Spiegelsubstrate begrenzter Spalt, der funktionsnotwendig ist, um eine kollisionsfreie Relativbewegung der benachbarten Spiegelelemente gegeneinander zu ermöglichen.

Bei jeder Spiegeleinheit sind in einem Zwischenraum zwischen dem Basiselement und dem Spiegelelement funktionelle Komponenten der Spiegeleinheit angeordnet. Beispielsweise kann jede Spiegeleinheit in dem Zwischenraum zwischen dem Basiselement und dem Spiegelsubstrat Komponenten eines Aufhängungssystems zur beweglichen Lagerung des Spiegelelements an dem Basiselement sowie Komponenten eines Aktuatorsystems zur Erzeugung von Bewegungen des Spiegelelements relativ zum Basiselement in Reaktion auf den Empfang von Steuersignalen aufweisen. In diesem Zwischenraum können außerdem noch Sensorelemente angeordnet sein, beispielsweise Positionssensorelemente, die die jeweilige Orientierung der Spiegelflächen relativ zu dem Basiselement erfassen. Auf der dem Spiegelelement zugewandten Oberseite des Basiselements können Komponenten einer Steuerelektronik angeordnet sein.

Das Aufhängungssystem verbindet das Spiegelsubstrat mechanisch mit dem Basiselement. Das Aufhängungssystem kann z.B. federelastische bzw. flexible Abschnitte oder Komponenten aufweisen, die die erforderliche Beweglichkeit bereitstellen. Das Aufhängungssystem kann Gelenke enthalten, die Komponenten oder Abschnitte davon gelenkig verbinden, z.B. in Form von Festkörpergelenken. Das Aktuatorsystem kann ein vom Aufhängungssystem unabhängig aufgebautes System sein, das Kräfte und Drehmomente für die Bewegung der Spiegelelemente bereitstellt. Es ist auch möglich, dass das Aufhängungssystem und das Aktuatorsystem integriert sind, indem Abschnitte des Aufhängungssystems auch als funktionale Teile des Aktuatorsystem fungieren. Komponenten der Sensorik können ebenfalls integriert sein.

Bei dieser Konstruktion können somit die gesamte Aktuatorik, Sensorik und weitere mechanische Elemente unterhalb der Spiegeloberfläche, d.h. zwischen dieser und der Trägerstruktur, angeordnet sein. Dadurch kann erreicht werden, dass der Flächenanteil der reflektierenden Spiegelflächen der Einzelspiegel an der Gesamtfläche der Mehrfachspiegelanordnung sehr groß werden kann.

Um eine höhere Integrationsdichte zu erreichen, werden im Fertigungsprozess zunehmend Technologien aus dem Bereich der Herstellung von mikro-elektro-mechanischen Systemen (kurz: MEMS) genutzt, zum Beispiel um Antriebselemente (Elemente des Aktuatorsystems), Mechanikelemente (beispielsweise Elemente des Aufhängungssystems) und/oder Sensorelemente oder dergleichen zu erzeugen. Solche MEMS-Prozesse basieren heutzutage im Wesentlichen auf Strukturierungsprozessen, in denen ein z.B. Ausgangssubstrat aus Silizium oder einer Silizium-Verbindung strukturiert wird und dadurch die erforderlichen Komponenten gestaltet werden.

Die Erfinder haben erkannt, dass den Vorteilen der Anwendung von MEMS-Techniken bei der Herstellung von Mehrfachspiegelanordnungen Nachteile gegenüberstehen. Dies gilt insbesondere für Anwendungen, die EUV-Strahlung nutzen. Bei diesen wird u.a. berücksichtigt, dass in einer wasserstoffhaltigen Atmosphäre unter der Einwirkung von energiereicher EUV-Strahlung durch Ionisierungsprozesse ein EUV-induziertes Wasserstoff-Plasma entstehen kann, welches positiv geladene Wasserstoffionen (H⁺-Ionen) und neutrale H*-Radikale enthält. Wasserstoffionen und -Radikale wirken u.a. auf Silizium stark ätzend, so dass es unter der Einwirkung von Wasserstoff-Plasma zu einem Ätzabtrag und dementsprechend zu Strukturveränderungen und anderen Degradationsprozessen an den Komponenten der Spiegeleinheiten kommen kann.

Aufgrund der Spalte zwischen den einzelnen Spiegelsubstraten können auch funktionskritische Komponenten, die in dem dahinter liegenden Zwischenraum zwischen Spiegelfläche bzw. Spiegelsubstrat und Trägerstruktur angeordnet sind, angegriffen werden. Dies gilt insbesondere für MEMS-Strukturen. Dazu können mehrere Effekte beitragen. Zum einen kann ein Wasserstoffionen enthaltendes Wasserstoff-Plasma im Bereich vor den Spiegelflächen generiert und dann durch die Spalte in den Zwischenraum gelangen und dort die Strukturen angreifen. Besonders kritisch ist es, wenn EUV-Strahlung durch die Spalte hindurch in den Zwischenraum zwischen Spiegelsubstrat und Trägerstruktur gelangen und dort Wasserstoffionen im Volumen der MEMS-Strukturen generieren kann. Dies kann beispielsweise dann der Fall sein, wenn am MMA Bereiche mit EUV-Strahlung ausgeleuchtet werden, deren laterale Ausdehnung größer als die typische laterale Ausdehnung der einzelnen Spiegelflächen ist.

Der Ätzabtrag an den hinter der Spiegelfläche liegenden Komponenten der Spiegeleinheiten, insbesondere das Ätzen von Silizium, kann vor allem zwei Probleme verursachen. Zum einen kann es zu Silizium-Ablagerungen auf optischen Oberflächen kommen, und zwar nicht nur an Oberflächen der Mehrfachspiegelanordnung, sondern gegebenenfalls auch durch Verschleppung auf anderen optischen Oberflächen. Dadurch können in relativ kurzen Zeiten erhebliche Transmissionsverluste verursacht werden, so dass die tatsächlich verfügbaren Nutzungsdauern von EUV-Anlagen deutlich gegenüber den theoretisch erwarteten Nutzungszeiten zurückbleiben. Außerdem können interne und externe Photoeffekte ausgelöst werden, die an funktionalen Strukturelementen einer Spiegeleinheit deren Eigenschaften, insbesondere die elektrischen Eigenschaften, verändern können, so dass es in relativ kurzer Zeit (z.B. schon nach weniger als einem Jahr) zu nicht mehr tolerierbaren Eigenschaftsänderungen und gegebenenfalls sogar zu völligen Ausfällen kommen kann.

Zusätzlich zu diesen durch unkontrollierte Ätzangriffe verursachten Fehlern kommen die bisher schon bekannten Beeinträchtigungen der Performance, zum Beispiel durch Eindringen von Kontaminationspartikeln aus Zinn oder Zinn-Verbindungen in den Bereich zwischen den Spiegelsubstraten und die Trägerstruktur. Diese können die Bewegungen von relativbeweglichen Strukturelementen blockieren oder hemmen und auch die Positionierung von Spiegeln bei der gesteuerten Verkippung beeinflussen, indem das Zusammenspiel zwischen Aktuatoren und Sensoren gestört wird. Weiterhin können sich Probleme durch strahlungsinduzierte Aufheizung sowie Degradationsprozesse und elektrische Störungen aufgrund von Plasmaströmen und Photoeffekt ergeben, insbesondere im Bereich von Flächen, die auftreffender EUV-Strahlung direkt ausgesetzt sind.

Auch wenn die Ätzproblematik bei DUV-Anwendungen nicht im Vordergrund steht, so können doch strahlungsinduzierte Aufheizeffekte und Funktionsstörungen durch induzierte photoelektrische Effekte die Funktionalitäten und die Lebensdauer auch in DUV-Anlagen erheblich einschränken.

Die Erfinder haben Lösungsansätze entwickelt, die dazu beitragen können, derartige Probleme erheblich zu reduzieren oder weitgehend zu verhindern.

Gemäß einer Formulierung der Erfindung können erhebliche Verbesserungen u.a. im Hinblick auf die geschilderte Ätzproblematik dadurch erreicht werden, dass die Seitenflächen der Spiegelsubstrate jeweils vollständig oder wenigstens abschnittsweise in einem von 90° abweichenden Winkel schräg zur zugeordneten Spiegelfläche bzw. zur Vorderfläche des Spiegelsubstrats orientiert sind. Dies stellt eine Abkehr von den bisher bekannten Konstruktionsprinzipen dar, wonach die Spiegelelemente jeweils so gestaltet sind, dass die Seitenflächen im Wesentlichen senkrecht zu der mit der Reflexionsbeschichtung versehene Vorderfläche bzw. zur Spiegelfläche stehen. Die Formulierung "im Wesentlichen senkrecht" bedeutet hier insbesondere, dass die Seitenflächen herkömmlicher Spiegelsubstrate im Rahmen der jeweiligen Fertigungstoleranzen an den Randbereichen der Spiegelflächen senkrecht zur reflektierenden Vorderseite orientiert waren. Anders ausgedrückt wurden nach Kenntnis der Erfinder bei gattungsgemäßen Mehrfachspiegelanordnungen bisher keine gezielten Maßnahmen getroffen, von dieser klassischen Auslegung abzuweichen.

Abweichend davon wird hier vorgeschlagen, bewusst die kompletten Seitenflächen oder wenigstens einen funktionswichtigen Abschnitt jeder der Seitenflächen so zu fertigen, dass in Bezug auf die Spiegelfläche eine Schrägstellung resultiert, die deutlich außerhalb der Fertigungstoleranzen des jeweiligen Herstellungsprozesses liegt. Man kann somit sagen, dass gemäß diesem Aspekt der Erfindung Randbereiche von Spiegelsubstraten als Schutzstrukturen ausgebildet sind, indem Spiegelsubstrat-Seitenflächen unmittelbar benachbarter Spiegelsubstrate jeweils vollständig oder wenigstens teilweise oder im Mittel in einem von 90° abweichenden Winkel schräg zur zugeordneten Spiegelfläche orientiert sind.

Dabei sind unterschiedliche Ausgestaltungen einer schrägen Seitenfläche möglich. Eine Seitenfläche kann als makroskopisch ebene Fläche über ihr volle (zwischen Vorderfläche und Rückfläche liegenden) Höhe im selben Winkel schräg zur Spiegelfläche orientiert sein. Verläuft die Rückfläche parallel zur Vorderfläche und ist die am selben Spiegelelement gegenüberliegende Seitenfläche symmetrisch dazu schräggestellt, so erhält das Spiegelsubstrat in einem zwischen den gegenüberliegenden Seitenflächen geführten Schnitt eine im Wesentlichen trapezförmige Querschnittsgestalt.

Eine Seitenfläche kann auch komplett oder in wenigstens einem Abschnitt konvex oder konkav gewölbt sein. Solche gekrümmten Flächenabschnitte können aufgrund der Herstellbarkeit und/oder im Hinblick auf die Funktion günstig sein. Eine Seitenfläche kann wenigstens einen Abschnitt aufweisen, der im Wesentlichen senkrecht zur Spiegelfläche orientiert ist. Solche senkrechten Abschnitte sollten aber vorzugsweise flächenmäßig klein sein, d.h. schräge Abschnitte sollten dominieren.

Es ist aber auch möglich, dass die Seitenfläche auf kleinerer Skala eine stufige Gestalt hat, aus der sich eine makroskopische schräge Orientierung der Seitenfläche ergibt.

Es gibt unterschiedliche Möglichkeiten der Realisierung dieses Konzepts der schräg orientierten Seitenflächen.

Gemäß einer Weiterbildung sind die Seitenflächen von Spiegelsubstraten unmittelbar benachbarter Spiegelsubstrate derart ausgebildet und orientiert, dass der zwischen unmittelbar benachbarten Spiegelsubstraten gebildete Spalt (jedenfalls bei unverkippten Spiegelelementen) eine Spaltbreite aufweist, die von der mit der Reflexionsbeschichtung versehene Vorderfläche eines Spiegelelements in Richtung des Basiselements kontinuierlich oder wenigstens in einem oder mehreren Abschnitten im Mittel zunimmt. Dadurch ist der Spalt bei Neutralstellung der Spiegelelemente an der Seite der Spiegelfläche, also an der Seite des Strahlungseintritts, enger als an der dem Basiselement zugewandten Seite (Strahlungsaustrittsseite).

Vorzugsweise ist die Auslegung so gewählt, dass die mit der Reflexionsbeschichtung versehene Vorderfläche eines Spiegelelements einen größeren Flächeninhalt aufweist als die vom äußeren Rand der Rückfläche umschlossene Fläche, wobei ein äußerer Rand der Rückfläche gegenüber einem äußeren Rand der Vorderfläche an allen Umfangspositionen um einen lateralen Versatz nach innen zurückgesetzt ist. Diese Geometrie kann auch so beschrieben werden, dass sich das Spiegelsubstrat von der spiegelnden Vorderseite in Richtung der Rückfläche bzw. in Richtung des Basiselements verjüngt. Die Rückfläche verläuft vorzugsweise im Wesentlichen parallel zur Vorderfläche.

Um die Vorteile dieses Ansatzes verstehen zu können, seien nachfolgend einige Erkenntnisse der Erfinder kurz erläutert. Die Erfinder haben erkannt, dass die Seitenflächen erheblich zur Einkopplung von eintreffender Strahlung in den Zwischenraum benachbarter Spiegelelemente beitragen können, insbesondere wenn benachbarte Spiegelelemente gegeneinander verkippt werden. Zu dieser unerwünschten Rolle trägt bei, dass beim Herstellungsprozess der Mehrfachspiegelanordnung in der Regel zusätzlich zur Vorderseite auch die daran angrenzenden Seitenflächen eine reflektierend wirkende Beschichtung erhalten. Diese ist für die bestimmungsgemäße Verwendung der Mehrfachspiegelanordnung nicht erforderlich, ergibt sich jedoch in der Regel automatisch, wenn keine Gegenmaßnahmen getroffen werden. Während die Seitenflächen in der Regel keine oder nur relativ wenig direkte Strahlung erhalten, wenn sich das zugehörige Spiegelelement in seiner unverkippten Neutralstellung (Kippwinkel = 0°) befindet und die Strahlung mit nicht zu großen Einfallswinkeln in Bezug auf eine Normale einer Basisebene eintritt, kann es sein, dass bei Verkippung des Spiegelelements ein größerer Anteil der einfallenden Strahlung unter mehr oder weniger großen Einfallswinkeln (grazing incidence) direkt auf Seitenflächen trifft. Ein nicht unerheblicher Teil der Strahlung kann dann ggf. verlustarm bzw. mit hoher Reflektivität an einer Seitenfläche reflektiert und mit deutlich geänderter Strahlrichtung in den Zwischenraum einer benachbarten Spiegeleinheit eingekoppelt werden. So kann es sein, dass durch einfache oder mehrfache Reflexion einfallender Strahlung an Seitenflächen verkippter Spiegelelemente schädliche Strahlung in Bereiche hinter benachbarten Spiegelelementen gelangen kann, die bei unverkippten Spiegelelementen "im Dunkeln" liegen, d.h. durch die Spiegelelemente abgeschattet werden. Somit kann es sein, dass hinter einem Spiegelelement auf Höhe des Basiselements nur ein relativ kleiner, gegen direkte Bestrahlung geschützter Bereich verbleibt, der zur Anbringung besonders strahlungsempfindlicher Komponenten genutzt werden kann.

Sind dagegen die Seitenflächen so schräg gestellt, dass sie hinter der Spiegelfläche abschnittsweise oder über ihre gesamte Höhe "nach innen fallen", so kann dieser schädliche Effekt abgeschwächt werden, so dass es zu einer Vergrößerung der strahlungsgeschützten Bereiche hinter den Spiegelelementen kommt. Dadurch ergibt sich mehr strahlungsgeschützter Bauraum hinter jedem Spiegelelement und eventuelle Degradationsprozesse sowie elektrische Störungen (Plasmaströme, Photoeffekt) aufgrund von schädlicher Strahlung können verlangsamt oder vollständig unterdrückt werden.

Das Ausmaß der Schrägstellung kann der jeweiligen Einbausituation bei der Nutzung angepasst sein. Vor allem der lokale Einfallswinkelbereich der EUV-Strahlung kann berücksichtigt werden. In der Regel muss die Schrägstellung nicht besonders ausgeprägt sein. Bei manchen Ausführungsformen kann der Versatz in der Größenordnung von 10 % oder weniger der (zwischen der Vorderfläche und der Rückfläche gemessene) Dicke bzw. Höhe des Spiegelsubstrats liegen. Insbesondere kann vorgesehen sein, dass der Versatz mindestens 3%, vorzugsweise mindestens 5% der Dicke/Höhe und/oder höchstens 15% % der Dicke/Höhe beträgt.

Alternativ oder zusätzlich kann es vorteilhaft sein, wenn der zwischen der Vorderfläche und der angrenzenden Seitenfläche am Übergang eingeschlossene Winkel im Bereich von 80° bis 89° liegt, insbesondere im Bereich von 84 ° bis 88°.

Ist der Winkel deutlich größer als die obere Grenze, so ist meist kaum eine Verbesserung gegenüber den herkömmlichen senkrechten Seitenflächen erzielbar. Liegt der Winkel dagegen deutlich unterhalb der unteren Grenze, so kann es sein, dass insbesondere in der Neutralstellung der Spiegelelemente bei mit relativ großen Einfallswinkeln schräg einfallender Strahlung mehr Intensität in den zu schützenden Bereich gelangt und/oder die geschützten (dunklen) Bereiche kleiner werden als im Falle herkömmlicher Lösungen mit senkrechten Seitenflächen.

Ein weiterer Ansatz besteht darin, die Herstellung so zu steuern, dass die Seitenflächen eine Oberflächenrauheit aufweisen, die mindestens eine Größenordnung (d.h. mindestens um einen Faktor 10) größer ist als die Oberflächenrauheit der mit der Reflexionsbeschichtung versehenen Vorderfläche. Die Oberflächenrauheit der Seitenflächen kann z.B. mindestens 100 nm RMS oder mindestens 1000 nm RMS betragen. Zum Vergleich: die Oberflächenrauheit von polierten optischen Oberflächen liegt bei den hier betrachteten Anwendungen im Bereich von weniger als 1 nm RMS, oder sogar weniger als 0,2 nm RMS. Diese Werte beziehen sich auf die sogenannte quadratische Rauheit (RMS = root mean square). Werden die Seitenflächen durch geeignete Maßnahmen mit starker Oberflächenrauheit gefertigt, so kann spekulare Reflexionen an den Seitenflächen weitgehend unterdrückt werden und auftreffende Strahlung kann lediglich in einen großen Raumwinkelbereich gestreut werden. Dadurch wird auf eine raue Seitenfläche einfallende Strahlung "unschädlich" gemacht, indem deren Energie räumlich verteilt und/oder im Bereich der Seitenfläche absorbiert wird.

Diese Maßnahme (Ausgestaltung der Seitenflächen mit starker Oberflächenrauheit) kann unabhängig von den sonstigen Merkmalen der Seitenflächen vorteilhaft sein, insbesondere auch bei Seitenflächen, die im Wesentlichen senkrecht zur Spiegelfläche stehen.

Der Lösungsansatz der schrägen Seitenflächen kann auch auf andere Weise umgesetzt werden.

Gemäß einer Weiterbildung ist vorgesehen, dass Randbereiche von Spiegelsubstraten als Ätzschutzstrukturen ausgebildet sind, indem Spiegelsubstrat-Seitenflächen unmittelbar benachbarter Spiegelelemente jeweils in einem von 90° abweichenden Winkel schräg zur zugeordneten Spiegelfläche derart orientiert sind, dass die schrägen Seitenflächen benachbarter Spiegelelemente einen Spalt bilden, der schräg zu den Spiegelflächen und/oder schräg zur einfallenden EUV-Strahlung und/oder schräg zu einer Basisebene der Mehrfachspiegelanordnung orientierten. Der Spalt kann so ausgelegt sein, dass zumindest dann, wenn sich die Spiegelelemente in ihrer Nullstellung befinden, ein direkter Strahlungsdurchtritt durch den Spalt bei senkrechtem Strahlungseinfall (normal incidence) (in Bezug auf die Basisebene) blockiert wird. Der Zwischenraum wird dadurch mithilfe der Spiegelsubstrate auch im Spaltbereich gegen eindringende EUV-Strahlung abgeschirmt. Die Abschirmung kann komplett bzw. vollständig sein. Es kann aber auch sein, dass nur eine teilweise Abschirmung erreicht wird.

Die Randbereiche der Spiegelsubstrate können so gestaltet sein, dass der Spalt angrenzend an die Spiegelflächen eine erste (vordere) Spaltöffnung mit einer ersten Spaltbreite und angrenzend an Rückseiten der Spiegelsubstrate eine zweite (hintere) Spaltöffnung mit einer zweiten Spaltbreite aufweist, wobei die erste Spaltöffnung und die zweite Spaltöffnung aufgrund der schrägen Orientierung des Spalts einen lateralen Versatz aufweisen, so dass eine für einen (direkten) Strahlungsdurchtritt wirksame effektive Spaltbreite des schrägen Spalts kleiner ist als die erste Spaltbreite und/oder die zweite Spaltbreite. Insbesondere wird eine verschwindende effektive Spaltbreite erreicht, also ein strahlungsundurchlässiger Spalt. Es kann auch sein, dass bei gegebener absoluter Spaltbreite die für den Strahlungsdurchtritt effektive Spaltbreite kleiner als die absolute Spaltbreite aber größer als Null ist. Die Spaltbreite kann z.B. bei Spiegelsubstraten mit Kantenlängen im Bereich von einem oder wenigen Millimetern und Dicken im Bereich von einem oder wenigen Zehntelmillimetern im Bereich von 10 µm bis 100 µm liegen, insbesondere im Bereich von 20 µm bis 60 µm.

Vorzugsweise ist der laterale Versatz zwischen der ersten Spaltöffnung und der zweiten Spaltöffnung mindestens so groß wie das Maximum aus der ersten Spaltbreite und der zweiten Spaltbreite. Bei der Auslegung sollte die Strahlrichtung am Einbauort berücksichtigt werden, so dass der effektive laterale Versatz, also der laterale Versatz senkrecht zur Strahlrichtung maßgeblich sein sollte. Dadurch kann erreicht werden, dass jedenfalls bei senkrechter oder nahezu senkrechter Inzidenz oder bei schrägem Strahlungseinfall der auf die Spiegelflächen einfallenden EUV-Strahlung keine EUV-Strahlung direkt durch die Spalte in den dahinterliegenden Zwischenraum gelangen kann.

Vorzugsweise sind die Spiegelsubstrat-Seitenflächen so orientiert, dass sich ein im Wesentlichen planparalleler Spalt ergibt, wenn die Spiegelelemente in ihrer jeweiligen Neutralstellung sind. Ein Spalt ist in diesem Sinne "im Wesentlichen planparallel", wenn die den Spalt begrenzenden Seitenflächen im Rahmen der Fertigungstoleranzen parallel zueinander verlaufen oder einen Winkel von weniger als maximal 10° einschließen. Unter anderem wird dadurch die Justage erleichtert.

Die Spiegelsubstrat-Seitenflächen benachbarter Spiegelelemente können so orientiert sein, dass sich auf einer Seite eines dazwischen gebildeten Spalts zwischen der Spiegelsubstrat-Seitenfläche und der Spiegelfläche ein (spitzer) Winkel von weniger als 90° und auf der gegenüberliegenden Seite ein (stumpfer) Winkel von mehr als 90° ergibt, wobei die Absolutwerte der Abweichungen von 90° auf beiden Seiten gleich oder nahezu gleich (Abweichungen bis zu 5°) sind.

In vielen Fällen hat es sich als zweckmäßig herausgestellt, wenn die schräge Orientierung der Spiegelsubstrat-Seitenflächen so gewählt ist, dass die Abweichung von einer 90°-Orientierung zur Spiegelfläche 10° oder mehr beträgt, wobei die Abweichung insbesondere im Bereich von 20° bis 30° liegen kann. Dadurch kann bei relativ kleinen absoluten Spaltbreiten ein guter Kompromiss zwischen Spaltbreite (diese sollte generell möglichst klein sein) und kollisionsfrei verfügbaren Schwenkbereichen realisiert werden.

Besonders bevorzugt sind Anordnungen, bei denen jedes Spiegelsubstrat an einander gegenüberliegenden Seiten jeweils schräge Spiegelsubstrat-Seitenflächen hat, die an einer der Seiten mit der Spiegelfläche einen Winkel von mehr als 90° oder von weniger als 90° einschließen und an der gegenüberliegenden Seite denselben Absolutwinkel, aber in entgegengesetzte Richtung. Dadurch erhält das Spiegelsubstrat in einem zwischen den gegenüberliegenden Seitenflächen geführten Schnitt eine im Wesentlichen trapezförmige Querschnittsgestalt. In einer Reihe aufeinanderfolgende Einzelspiegel haben diese dann vorzugsweise abwechselnd umgekehrte trapezförmige Querschnittsgestalt, so dass sich die Orientierung der dazwischenliegenden schrägen Spalte von Spalt zu Spalt alternierend ändert. Vorzugsweise gilt dies in allen Richtungen, in denen Spiegelsubstrate in Reihe aufeinanderfolgen, so dass z.B. bei Einzelspiegeln mit quadratischer Spiegelfläche die Spiegelsubstrate die Gestalt einen Viereckpyramidenstumpf haben können.

Es kann somit so sein, dass Randbereiche von Spiegelsubstraten als Ätzschutzstrukturen ausgebildet sind, indem Spiegelsubstrat-Seitenflächen unmittelbar benachbarter Spiegelsubstrate jeweils in einem von 90° abweichenden Winkel schräg zur zugeordneten Spiegelfläche orientiert sind.

Durch die Schrägstellung der Seitenflächen können die Randbereiche der Spiegelsubstrate auf unterschiedliche Weise wirkende Beiträge zum Schutz der dahinterliegenden Komponenten leisten und somit auch als Bestandteil eines Ätzschutzssystems und/oder eines Systems zum Schutz vor elektrischen Störungen wirken.

Gemäß einer Formulierung dieses Aspekts der Erfindung ist die Mehrfachspiegelanordnung somit mit einem Ätzschutzsystem ausgestattet, welches u.a. dazu konfiguriert ist, einen materialabtragenden und/oder strukturverändernden Ätzangriff von durch EUV-Strahlung induziertem Wasserstoff-Plasma auf zwischen den Spiegelflächen und der Trägerstruktur angeordnete Komponenten der Spiegeleinheiten zu verhindern oder im Vergleich zu Spiegeleinheiten ohne Ätzschutzsystem zu reduzieren. Dabei umfasst das Ätzschutzsystem Ätzschutzstrukturen. Ätzschutzstrukturen können, wie beschrieben, an den Spiegelelementen ausgebildet oder angeordnet sein. Ätzschutzstrukturen können auch an den Basiselementen und/oder an Komponenten des Aufhängungssystems und/oder an Komponenten des Aktuatorsystems und/oder an Komponenten eines ggf. vorhandenen Sensorsystems ausgebildet oder angeordnet sein.

Eine "Ätzschutzstruktur" im Sinne dieser Anmeldung ist eine strukturelle Komponente der Mehrfachspiegelanordnung, die besonders dazu ausgelegt und wirksam ist, der beschriebenen Ätzproblematik entgegenzuwirken. Im Vergleich zu einer Mehrfachspiegelanordnung des Standes der Technik kann eine Ätzschutzstruktur dadurch bereitgestellt werden, dass diese als zusätzliches strukturelles Merkmal an der konventionellen Struktur angebracht ist. Es ist auch möglich, eine Ätzschutzstruktur zu schaffen, indem eine bei einer konventionellen Mehrfachspiegelanordnung vorhandene Komponente eine besondere Gestaltung bzw. Formgebung erhält, die einen verbesserten Schutz gegen Ätzangriffe bietet.

Dadurch, dass mithilfe des Ätzschutzsystems bzw. der Ätzschutzstrukturen die oben genannten Ätzangriffe in ihrer Wirkung vermindert oder sogar völlig verhindert werden können, können die durch Ätzen verursachten Degradationserscheinungen weitgehend vermieden oder jeweils in ihrer zeitlichen Entwicklung so weit verlangsamt werden, dass ein produktiver Betrieb über erheblich längere Nutzungsdauern möglich ist als in Abwesenheit von Ätzschutzsystemen. Dadurch, dass das Ätzschutzsystem an einer oder mehreren Komponenten einer Spiegeleinheit Ätzschutzstrukturen umfasst, die an der jeweiligen Komponente ausgebildet oder angebracht sind, können diese gleich bei der Herstellung der Mehrfachspiegelanordnung entsprechend erzeugt und/oder angebracht werden und müssen nicht als gesonderte Einheiten hergestellt und gegebenenfalls gesondert eingebaut und gegenüber der Mehrfachspiegelanordnung justiert werden.

Mithilfe der Ätzschutzstrukturen können die durch Ätzangriff verursachten Probleme auf unterschiedlichen Wegen reduziert oder vermieden werden. Eine Ätzschutzstruktur kann beispielsweise so ausgebildet sein, dass eine Einstrahlung z.B. von EUV-Strahlung in den Zwischenraum zwischen Spiegelfläche und Trägerstruktur verhindert oder gegenüber einer Konstruktion ohne Ätzschutzstruktur vermindert wird. Damit kann die Generierung von ätzendem Plasma im Zwischenraum vermieden und dadurch die Ätzrate in diesem Bereich reduziert werden. Alternativ oder zusätzlich ist es auch möglich, Ätzschutzstrukturen so auszulegen, dass vor den Spiegelflächen generiertes Plasma daran gehindert wird, in größerem Umfang durch die Spalte in den Zwischenraum einzudringen und dort zum Ätzangriff beizutragen.

Vorzugsweise ist wenigstens das Basiselement, das Aufhängungssystem und das Aktuatorsystem als MEMS-Struktur aus Silizium (Si) oder einer Silizium-Verbindung ausgebildet. Dann können für die Herstellung kleiner Strukturen gängige MEMS-Techniken gut adaptiert werden. Es kann jedoch auch vorgesehen sein, dass zumindest ein Teil der Strukturen, insbesondere das Spiegelsubstrat, aus einem nicht oder in geringerem Maße als Silizium durch Ätzangriff angreifbaren Material, wie z.B. Aluminiumoxid (Al₂O₃) gestaltet ist.

Gemäß einer Weiterbildung kann vorgesehen sein, dass unmittelbar benachbarte Spiegelelemente bzw. deren Spiegelflächen permanent oder temporär in der Höhe zueinander versetzt angeordnet sind, so dass ein durch eine der Spiegelflächen definierter erster Referenzpunkt gegenüber einem durch die unmittelbar benachbarte Spiegelfläche definierten zweiten Referenzpunkt mit einem Höhenabstand übereinanderliegen, wobei der Referenzpunkt dem geometrischen Mittelpunkt einer Spiegelfläche entspricht. Durch den Höhenversatz, der dann auch im Bereich des zwischen den Spiegelelementen gebildeten Spalts in gleicher oder ähnlicher Größe vorliegt, wird es möglich, relativ große kollisionsfrei verfügbare Kippbereiche zu realisieren, da durch den Höhenversatz die Störkonturen, die durch die jeweils gegenüberliegenden Ränder der Spiegelelemente gebildet werden, einen größeren Abstand voneinander erhalten. Der Höhenversatz kann in einer vorher festgelegten und damit fixierten Weise vorliegen. Er kann z. B. im Bereich von 25% bis 75% der Substratdicke liegen. Dadurch ist eine besonders wirksame Überlappung mit Nachbarspiegelsubstraten realisierbar.

Die Mehrfachspiegelanordnung kann eine steuerbare Höhenverstelleinrichtung zur reversiblen, stufenlosen Höhenverstellung einzelner Spiegelelemente gegenüber benachbarten Spiegelelementen in Reaktion auf Steuersignale aufweisen.

Bei manchen Ausführungsformen ist dazu vorgesehen, dass das Aktuatorsystem zur Erzeugung einer Bewegung eines Spiegelelements nicht nur in zwei rotatorischen, sondern auch in einem translatorischen Freiheitsgrad ausgelegt ist, wobei der translatorische Freiheitsgrad für eine steuerbare Höhenverstellung genutzt werden kann. Der translatorische Freiheitsgrad kann einer Bewegung des Spiegelelements entlang einer Translationsachse entsprechen, die senkrecht oder schräg auf Rotationsachsen der rotatorischen Freiheitsgrade steht. Die Rotationsachsen der rotatorischen Freiheitsgrade liegen vorzugsweise im Wesentlichen orthogonal zueinander in einer Ebene und die Translationsachse des translatorischen Freiheitsgrads verläuft senkrecht zu der Ebene.

Alternativ oder zusätzlich können die Basiselemente individuell höhenverstellbar sein, so dass die kompletten Spiegeleinheiten angehoben und wieder abgesenkt werden können, z.B. mithilfe wenigstens einer dickenveränderlichen piezoelektrischen Schicht zwischen Trägerstruktur und Basiselement.

Der Höhenversatz kann, wie beschrieben, unter anderem aus Kollisionsgründen vorteilhaft und daher gewünscht sein. Im optischen Gesamtsystem, welches die EUV-Mehrfachspiegelanordnung enthält, beispielsweise also in einem Beleuchtungssystem für eine EUV-Anlage, kann ein entsprechender Vorhalt vorgesehen sein, um zu berücksichtigen, dass benachbarte Spiegelelemente einer EUV-Mehrfachspiegelanordnung in ihrer Höhe relativ zueinander versetzt sind, so dass sie an in Einstrahlrichtung gegeneinander versetzten Ebenen oder Flächen reflektieren.

Bei manchen Ausführungsformen ist vorgesehen, dass eine Steuerung der Höhenverstelleinrichtung derart konfiguriert ist, dass eine Höhenverstellung eines Spiegelelements in Abhängigkeit von der Kippstellung benachbarter Spiegelelemente erzeugbar ist. Dadurch kann unter anderem erreicht werden, dass schaltstellungsabhängige Kollisionen vermieden werden und die Ausleuchtung je nach Schaltzustand optimiert wird.

Die steuerbare relative Höhenverstellung benachbarter Spiegelelemente einer EUV-Mehrfachspiegelanordnung kann auch unabhängig von den sonstigen Merkmalen der hier beschriebenen EUV-Mehrfachspiegelanordnungen vorteilhaft und eine für sich schutzfähige Erfindung sein, beispielsweise bei EUV-Mehrfachspiegelanordnungen, deren Spiegelelemente senkrecht zur Spiegelfläche orientierte Seitenflächen und damit keine schrägen Spalte aufweisen.

Alternativ oder zusätzlich zu den bisher genannten Maßnahmen ist bei manchen Ausführungsformen vorgesehen, dass das Ätzschutzsystem Ätzschutzstrukturen in Form von Strahlungsfallenelementen umfasst, die eine Strahlungsauftrefffläche aufweisen, welche jeweils an der den Spiegelflächen abgewandten Rückseite der Spiegelsubstrate im Bereich eines Spaltes angeordnet ist. Eine solche Strahlungsauftrefffläche kann in unmittelbarer Nähe der trägerseitigen zweiten Spaltöffnung eines Spalts angeordnet sein und diesen zu beiden Seiten überragen, so dass auch schräg durch den Spalt gelangende EUV-Strahlen noch auf die Strahlungsauftrefffläche fallen und dadurch in ihrer negativen Wirkung entschärft werden können. Die Strahlungsfallenelemente können ggf. als MEMS-Strukturen bei der Herstellung der Spiegeleinheiten ggf. integral mit anderen Strukturen erzeugt werden.

Die Strahlungsfallenelemente können gegebenenfalls unterschiedliche Funktionsmechanismen einzeln oder in Kombination miteinander nutzen. Gemäß einer Ausführungsform besteht ein Strahlungsfallenelement wenigstens im Bereich der Strahlungsauftrefffläche aus einem Funktionsmaterial, welches ein für EUV-Strahlung absorbierend wirkendes Absorbermaterial ist und/oder welches ein Rekombinationskatalysator ist, der bei Kontakt mit Wasserstoffionen sowie Wasserstoffatomen die Rekombinationswahrscheinlichkeit zur Bildung von H₂-Molekülen erhöht. Besonders geeignete Funktionsmaterialien sind nach derzeitigen Erkenntnissen Materialien aus der folgenden Gruppe: Ruthenium (Ru), Platin (Pt), Rhenium (Re), Rhodium (Rh), Iridium (Ir), Molybdän (Mo), Nickel (Ni) und Eisen (Fe). Diese haben sowohl absorbierende als auch rekombinationsfördernde Eigenschaften.

Es kann vorgesehen sein, dass die Strahlungsfallenelemente abschnittsweise in der Höhe verstellbar sind. Eine Höheneinstellung des jeweiligen Strahlungsfallenelements kann ggf. in Abhängigkeit von den Kippstellungen und/oder Höhenstellungen benachbarter Spiegelelemente erzeugt werden, um einen besseren individuellen Ätzschutz zu bieten.

Ein weiterer Ansatz zur Reduzierung der Ätzproblematik besteht gemäß einer Weiterbildung darin, dass das Ätzschutzsystem wenigstens eine Schutzmembran aufweist, die einen Spaltabdeckabschnitt aufweist, der einen zwischen unmittelbar benachbarten Spiegelsubstraten gebildeten Spalt überbrückt und die den Spalt begrenzenden Spiegelsubstrate kontaktiert, insbesondere daran befestigt ist. Die Schutzmembran bzw. der Spaltabdeckabschnitt werden also unmittelbar von den benachbarten Spiegelelementen getragen und können daher mit diesen ein- und ausgebaut werden. Es handelt sich also nicht um gesonderte Elemente, vielmehr kann ein Spaltabdeckabschnitt gemeinsam mit den angrenzenden, den Spaltabdeckabschnitt tragenden Spiegelelementen hergestellt werden. Gegebenenfalls kann die Schutzmembran bzw. ein Spaltabdeckabschnitt auch nachträglich an den Spiegelelementen befestigt werden. Ein Spaltabdeckabschnitt kann an der Vorderseite der Spiegelelemente angeordnet sein und somit die erste Spaltöffnung abdecken. Dann entsteht schon ein Schutz für den Bereich des Spalts. Es ist jedoch auch möglich, dass ein Spaltabdeckabschnitt im Bereich der zweiten Spaltöffnung angebracht wird, also erst nach Durchlaufen des Spalts wirkt.

Für die Ausgestaltung des Spaltabdeckabschnitts gibt es unterschiedliche Möglichkeiten. Bei manchen Ausführungsformen besteht der Spaltabdeckabschnitt insgesamt aus einem EUVtransparenten Material. Dadurch ist es zwar möglich, dass EUV-Strahlung durch den Spaltabdeckabschnitt hindurch in den Zwischenraum gelangt. Es wird jedoch verhindert, dass Wasserstoff-Plasma vom Bereich vor der Spiegelanordnung in den Zwischenraum gelangt, so dass insoweit eine Ätzangriffsreduzierung geleistet wird. Ebenfalls verhindert diese Anordnung eine Blockade zweier benachbarter Kanäle aufgrund von Partikelkontamination.

Bei anderen Ausführungsformen weist die Schutzmembran im Bereich des Spiegelabdeckabschnitts ein für EUV-Strahlung absorbierend wirkendes Absorbermaterial auf, das zum Beispiel aus der Gruppe: Ru, Pt, Re, Rh, Ir, Mo, Ni, Fe ausgewählt sein kann. Bei diesen Varianten schützt der Spaltabdeckabschnitt nicht nur vor in den Zwischenraum eindringendem Wasserstoff-Plasma, sondern es wird auch EUV-Strahlung blockiert, so dass insoweit auch kein neues Wasserstoff-Plasma im Zwischenraum generiert werden kann.

In Ausführungsformen, bei denen eine Schutzmembran an der Eingangsseite der Spalte, also auf Höhe der Spiegelvorderseite, angebracht ist, kann diese auf der Außenseite der Spiegelfläche in deren Randbereich fixiert sein. Wenn es sich um eine EUV-transparente Schutzmembran handelt, kann diese auch als großflächige Membran über viele benachbarte Spiegelflächen hinweg auf diese aufgebracht werden und dabei auch die dazwischenliegenden Spalte überbrücken. Die Membran kann so flexibel gestaltet sein, dass die Spiegel auch relativ zueinander verkippt werden können, ohne dass der Spaltabdeckabschnitt, der den dazwischenliegenden Spalt überdeckt, mechanisch übermäßig belastet wird.

Gemäß einer Weiterbildung ist vorgesehen, dass die Schutzmembran an der Vorderseite der Spiegelsubstrate als Teil einer Mehrlagen-Schichtanordnung zwischen den Spiegelsubstraten und der Reflexionsbeschichtung angeordnet ist. Dadurch kann erreicht werden, dass die freie Oberfläche der Reflexionsbeschichtung nicht durch die Schutzmembran belegt ist, wodurch besonders hohe Reflektivitäten möglich sind, da die Mehrlagen-Schichtanordnung nicht durch eine Membran abgedeckt ist.

Es ist auch möglich, dass eine Schutzmembran an der Rückseite der Spiegelsubstrate angeordnet ist. Bei Varianten mit Strahlungsfallenelementen kann eine Schutzmembran z.B. zwischen der Rückseite des Spiegelsubstrats und einer Vorderseite oder einer Rückseite eines Strahlungsfallenelements angeordnet sein. In Fällen mit höhenverstellbar gelagerten Strahlungsfallenelementen kann durch die Schichtspannung der Schutzmembran zwischen der Spiegeleinheit und dem Strahlungsfallenelement erreicht werden, dass das Strahlungsfallenelement in Höhenverstellrichtung mitgenommen wird, so dass eine kippstellungsabhängige Höhenverstellung des Strahlungsfallenelements erreicht werden kann. Ein gesonderter Aktuator zur Höhenverstellung des Strahlungsfallenelements kann dadurch eingespart werden.

Alternativ oder zusätzlich zu einer oder mehreren der genannten Maßnahmen kann vorgesehen sein, dass das Ätzschutzsystem wenigstens eine Ätzschutzstruktur in Form einer Ätzschutzschicht aufweist, die in einem durch Ätzangriff gefährdeten Bereich auf eine aus einem Komponentenmaterial bestehende Komponente der Spiegeleinheit aufgebracht ist, wobei die Ätzschutzschicht wenigstens ein Schutzschichtmaterial aufweist, das gegenüber einem Ätzangriff mit Wasserstoffionen eine höhere Ätzbeständigkeit besitzt als das Komponentenmaterial. Bei Komponenten aus Silizium oder einer Silizium-Verbindung kann eine Ätzschutzschicht beispielsweise aus Aluminium in nicht-oxidiertem Zustand oder in einem oxidierten Zustand, also aus Al₂O₃, bestehen.

Die Anwendung der Erfindung und ihrer Ausführungsbeispiele ist nicht auf Spiegeleinheiten beschränkt, deren Komponenten mittels einer MEMS-Fertigungstechnologie auf Basis von Silizium oder einer Silizium-Verbindung hergestellt werden. So ist es möglich, einige oder alle durch Ätzangriff gefährdete Komponenten wenigstens in denjenigen Flächenbereichen, die potenziell einem Ätzangriff ausgesetzt sind, aus einem gegen Ätzangriff besonders resistenten Material zu fertigen, beispielsweise aus Aluminiumoxid.

Die Erfindung betrifft auch ein Beleuchtungssystem für eine EUV-Anlage, wobei das Beleuchtungssystem dazu ausgebildet ist, im Betrieb der EUV-Anlage EUV-Strahlung einer EUV-Strahlungsquelle zu empfangen und aus mindestens einem Anteil der empfangenen EUV-Strahlung Beleuchtungsstrahlung zu formen, die in ein Beleuchtungsfeld in einer Austrittsebene des Beleuchtungssystems gerichtet ist. Das Beleuchtungssystem weist mindestens eine EUV-Mehrfachspiegelanordnung der in diese Anmeldung beschriebenen Art auf.

Bei der EUV-Anlage kann es sich z.B. um eine Projektionsbelichtungsanlage für die EUV-Mikrolithographie oder um eine mit EUV-Strahlung arbeitende Maskeninspektionsanlage zur Inspektion von Masken (Retikeln) für die EUV-Mikrolithographie handeln.

### KURZBESCHREIBUNG DER ZEICHNUNGEN

Weitere Vorteile und Aspekte der Erfindung ergeben sich aus den Ansprüchen und aus der Beschreibung von Ausführungsbeispielen der Erfindung, die nachfolgend anhand der Figuren erläutert sind.
- Fig. 1: zeigt schematisch optische Komponenten einer EUV-Mikrolithographie-Projektionsbelichtungsanlage mit einem Beleuchtungssystem, das einen oder mehrere EUV-Mehrfachspiegelanordnungen gemäß einem Ausführungsbeispiel enthält;
- Fig. 2: zeigt einen schematischen Ausschnitt einer konventionellen EUV-Mehrfachspiegelanordnung in einer H⁺-Ionen enthaltenden Plasmaumgebung;
- Fig. 3: zeigt einen senkrechten Schnitt durch einen Übergangsbereich zwischen zwei unmittelbar benachbarten Spiegeleinheiten, wobei zwischen den Spiegelsubstraten ein EUV-Strahlung blockierender schräger Spalt liegt;
- Fig. 4A bis 4D: illustrieren den abschirmenden Effekt schräggestellter Spalte im Vergleich zu senkrecht verlaufenden Spalten des Stands der Technik;
- Fig. 5A bis 5C: zeigen Beispiele, bei denen unmittelbar benachbarte Spiegelelemente permanent oder zeitweise in der Höhe zueinander versetzt angeordnet sind;
- Fig. 6: zeigt ein Ausführungsbeispiel mit Ätzschutzstrukturen in Form von Strahlungsfallenelementen hinter den Spalten;
- Fig. 7A bis 7F: zeigen Ausführungsbeispiele mit Ätzschutzstrukturen in Form einer von den Spiegelelementen getragenen Schutzmembran mit Spaltabdeckabschnitten;
- Fig. 8A und 8B: zeigen zwei Möglichkeiten zur Anbringung einer Schutzmembran im Bereich der Reflexionsbeschichtung;
- Fig. 9A bis 9C: veranschaulichen schematisch eine erste Variante eines Herstellverfahrens für eine Mehrfachspiegelanordnung mit schrägen Spalten;
- Fig. 10A bis 10C: veranschaulichen schematisch eine zweite Variante eines Herstellverfahrens für eine Mehrfachspiegelanordnung mit schrägen Spalten;
- Fig. 11: zeigt schematisch ein Ausführungsbeispiel, bei dem die Spiegelsubstrate schräggestellte Seitenflächen aufweisen, so dass die Spaltbreite in Richtung Basiselement zunimmt;
- Fig. 12A, 12B, 12C: zeigen alternative Gestaltungsmöglichkeiten für schräggestellte Seitenflächen;
- Fig. 13: zeigt ein Diagramm zur Erläuterung von Simulationsrechnungen, die den Zusammenhang zwischen Kippstellungen der Spiegelelemente und der Bestrahlung der Basiselemente beschreiben;
- Fig. 14A und 14B: zeigen einen Vergleich der Bestrahlungsverhältnisse bei herkömmlichen Spiegelelementen mit senkrechten Seitenflächen (Fig. 14A) und bei einen Ausführungsbeispiel mit schrägen Seitenflächen (Fig. 14B).

### DETAILLIERTE BESCHREIBUNG DER AUSFÜHRUNGSBEISPIELE

Nachfolgend werden Beispiele für Ausgestaltungen von Mehrfachspiegelanordnungen beispielhaft anhand von Nutzungsmöglichkeiten in EUV-Anlagen aus dem Bereich der Mikrolithographie erläutert. Eine Mehrfachspiegelanordnung mit für EUV-Strahlung reflektierend wirkenden Reflexionsschichten wird hier als EUV-Mehrfachspiegelanordnung bezeichnet.

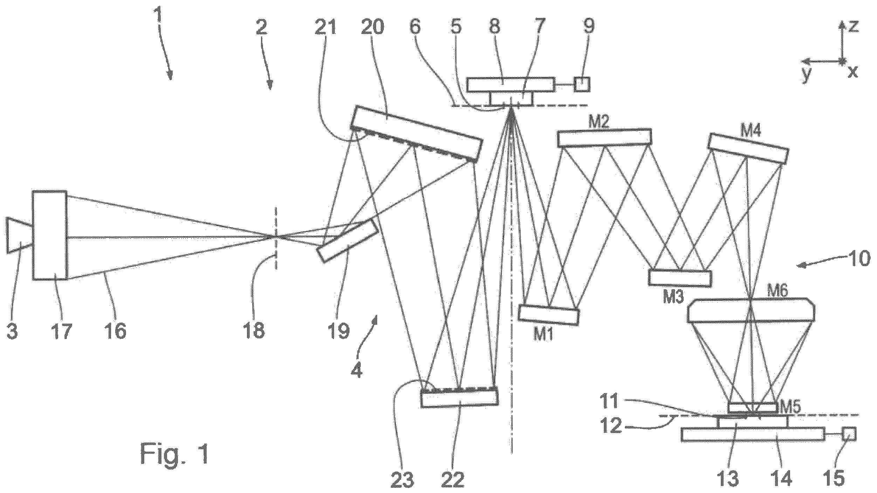

Im Folgenden werden zunächst unter Bezugnahme auf die Figur 1 exemplarisch die wesentlichen Bestandteile einer Projektionsbelichtungsanlage 1 für die Mikrolithographie beschrieben. Die Beschreibung des grundsätzlichen Aufbaus der Projektionsbelichtungsanlage 1 sowie deren Bestandteile sei hierbei nicht einschränkend verstanden.

Ein Beleuchtungssystem 2 der Projektionsbelichtungsanlage 1 hat neben einer Strahlungsquelle 3 eine Beleuchtungsoptik 4 zur Beleuchtung eines Objektfeldes 5 in einer Objektebene 6. Belichtet wird hierbei ein im Objektfeld 5 angeordnetes Retikel 7. Das Retikel 7 ist von einem Retikelhalter 8 gehalten. Der Retikelhalter 8 ist über einen Retikelverlagerungsantrieb 9 insbesondere in einer Scanrichtung verlagerbar.

In der Figur 1 ist zur Erläuterung ein kartesisches xyz-Koordinatensystem eingezeichnet. Die x-Richtung verläuft senkrecht zur Zeichenebene hinein. Die y-Richtung verläuft horizontal und die z-Richtung verläuft vertikal. Die Scanrichtung verläuft in der Fig. 1 längs der y-Richtung. Die z-Richtung verläuft senkrecht zur Objektebene 6.

Die Projektionsbelichtungsanlage 1 umfasst eine Projektionsoptik 10. Die Projektionsoptik 10 dient zur Abbildung des Objektfeldes 5 in ein Bildfeld 11 in einer Bildebene 12. Die Bildebene 12 verläuft parallel zur Objektebene 6. Alternativ ist auch ein von 0° verschiedener Winkel zwischen der Objektebene 6 und der Bildebene 12 möglich.

Abgebildet wird eine Struktur auf dem Retikel 7 auf eine lichtempfindliche Schicht eines im Bereich des Bildfeldes 11 in der Bildebene 12 angeordneten Wafers 13. Der Wafer 13 wird von einem Waferhalter 14 gehalten. Der Waferhalter 14 ist über einen Waferverlagerungsantrieb 15 insbesondere längs der y-Richtung verlagerbar. Die Verlagerung einerseits des Retikels 7 über den Retikelverlagerungsantrieb 9 und andererseits des Wafers 13 über den Waferverlagerungsantrrieb 15 kann synchronisiert zueinander erfolgen.

Bei der Strahlungsquelle 3 handelt es sich um eine EUV-Strahlungsquelle. Die Strahlungsquelle 3 emittiert insbesondere EUV-Strahlung 16, welche im Folgenden auch als Nutzstrahlung oder Beleuchtungsstrahlung bezeichnet wird. Die Nutzstrahlung hat insbesondere eine Wellenlänge im Bereich zwischen 5 nm und 30 nm. Bei der Strahlungsquelle 3 kann es sich um eine Plasmaquelle handeln, zum Beispiel um eine LPP (Laser Produced Plasma, mithilfe eines Lasers erzeugtes Plasma-Quelle oder um eine DPP (Gas Discharged Produced Plasma, mittels Gasentladung erzeugtes Plasma-Quelle). Es kann sich auch um eine synchrotronbasierte Strahlungsquelle handeln. Bei der Strahlungsquelle 3 kann es sich um einen Freie-Elektronen-Laser (Free-Electron-Laser, FEL) handeln.

Die Beleuchtungsstrahlung 16, die von der Strahlungsquelle 3 ausgeht, wird von einem Kollektor 17 gebündelt. Bei dem Kollektor 17 kann es sich um einen Kollektor mit einer oder mit mehreren ellipsoidalen und/oder hyperboloiden Reflexionsflächen handeln. Die mindestens eine Reflexionsfläche des Kollektors 11 kann im streifenden Einfall (Grazing Incidence, Gl), also mit Einfallswinkeln größer als 45°, oder im normalen Einfall (Normal Incidence, NI), also mit Einfallwinkeln kleiner als 45°, mit der Beleuchtungsstrahlung 16 beaufschlagt werden. Der Kollektor 11 kann einerseits zur Optimierung seiner Reflektivität für die Nutzstrahlung und andererseits zur Unterdrückung von Falschlicht strukturiert und/oder beschichtet sein.

Nach dem Kollektor 17 propagiert die Beleuchtungsstrahlung 16 durch einen Zwischenfokus in einer Zwischenfokusebene 18. Die Zwischenfokusebene 18 kann eine Trennung zwischen einem Strahlungsquellenmodul, aufweisend die Strahlungsquelle 3 und den Kollektor 17, und der Beleuchtungsoptik 4 darstellen.

Die Beleuchtungsoptik 4 umfasst einen Umlenkspiegel 19 und diesem im Strahlengang nachgeordnet einen ersten Facettenspiegel 20. Bei dem Umlenkspiegel 19 kann es sich um einen planen Umlenkspiegel oder alternativ um einen Spiegel mit einer über die reine Umlenkungswirkung hinaus bündelbeeinflussenden Wirkung handeln. Alternativ oder zusätzlich kann der Spiegel 19 als Spektralfilter ausgeführt sein, der eine Nutzlichtwellenlänge der Beleuchtungsstrahlung 16 von Falschlicht einer hiervon abweichenden Wellenlänge trennt. Sofern der erste Facettenspiegel 20 in einer Ebene der Beleuchtungsoptik 4 angeordnet ist, die zur Objektebene 6 als Feldebene optisch konjugiert ist, wird dieser auch als Feldfacettenspiegel bezeichnet. Der erste Facettenspiegel 20 umfasst eine Vielzahl von einzelnen ersten Facetten 21, welche im Folgenden auch als Feldfacetten bezeichnet werden. Von diesen Facetten 21 sind in der Fig. 1 nur beispielhaft einige dargestellt.

Die ersten Facetten 21 können als makroskopische Facetten ausgeführt sein, insbesondere als rechteckige Facetten oder als Facetten mit bogenförmiger oder teilkreisförmiger Randkontur. Die ersten Facetten 21 können als plane Facetten oder alternativ als konvex oder konkav gekrümmte Facetten ausgeführt sein.

Wie beispielsweise aus der DE 10 2008 009 600 A1 bekannt ist, können die ersten Facetten 21 selbst jeweils auch aus einer Vielzahl von Einzelspiegeln, insbesondere einer Vielzahl von Mikrospiegeln, zusammengesetzt sein. Der erste Facettenspiegel 20 kann insbesondere als mikroelektromechanisches System (MEMS-System) ausgebildet sein. Für Details wird auf die DE 10 2008 009 600 A1 verwiesen.

Zwischen dem Kollektor 17 und dem Umlenkspiegel 19 verläuft die Beleuchtungsstrahlung 16 horizontal, also längs der y-Richtung.

Im Strahlengang der Beleuchtungsoptik 4 ist dem ersten Facettenspiegel 20 nachgeordnet ein zweiter Facettenspiegel 22. Sofern der zweite Facettenspiegel 22 in einer Pupillenebene der Beleuchtungsoptik 4 angeordnet ist, wird dieser auch als Pupillenfacettenspiegel bezeichnet. Der zweite Facettenspiegel 22 kann auch beabstandet zu einer Pupillenebene der Beleuchtungsoptik 4 angeordnet sein. In diesem Fall wird die Kombination aus dem ersten Facettenspiegel 20 und dem zweiten Facettenspiegel 22 auch als spekularer Reflektor bezeichnet. Spekulare Reflektoren sind bekannt aus der US 2006/0132747 A1, der EP 1 614 008 B1 und der US 6,573,978.

Der zweite Facettenspiegel 22 umfasst eine Mehrzahl von zweiten Facetten 23. Die zweiten Facetten 23 werden im Falle eines Pupillenfacettenspiegels auch als Pupillenfacetten bezeichnet.

Bei den zweiten Facetten 23 kann es sich ebenfalls um makroskopische Facetten, die beispielsweise rund, rechteckig oder auch hexagonal berandet sein können, oder alternativ um aus Mikrospiegeln zusammengesetzte Facetten handeln. Diesbezüglich wird ebenfalls auf die DE 10 2008 009 600 A1 verwiesen.

Die zweiten Facetten 23 können plane oder alternativ konvex oder konkav gekrümmte Reflexionsflächen aufweisen.

Die Beleuchtungsoptik 4 bildet somit ein doppelt facettiertes System. Dieses grundlegende Prinzip wird auch als Wabenkondensor (Fly's Eye Integrator) bezeichnet.

Es kann vorteilhaft sein, den zweiten Facettenspiegel 22 nicht exakt in einer Ebene, welche zu einer Pupillenebene der Projektionsoptik 7 optisch konjugiert ist, anzuordnen.

Mit Hilfe des zweiten Facettenspiegels 22 werden die einzelnen ersten Facetten 21 in das Objektfeld 5 abgebildet. Der zweite Facettenspiegel 22 ist der letzte bündelformende oder auch tatsächlich der letzte Spiegel für die Beleuchtungsstrahlung 16 im Strahlengang vor dem Objektfeld 5.

Bei einer weiteren, nicht dargestellten Ausführung der Beleuchtungsoptik 4 kann im Strahlengang zwischen dem zweiten Facettenspiegel 22 und dem Objektfeld 5 eine Übertragungsoptik angeordnet sein, die insbesondere zur Abbildung der ersten Facetten 21 in das Objektfeld 5 beiträgt. Die Übertragungsoptik kann genau einen Spiegel, alternativ aber auch zwei oder mehr Spiegel aufweisen, welche hintereinander im Strahlengang der Beleuchtungsoptik 4 angeordnet sind. Die Übertragungsoptik kann insbesondere einen oder zwei Spiegel für senkrechten Einfall (NI-Spiegel, Normal Incidence Spiegel) und/oder einen oder zwei Spiegel für streifenden Einfall (GI-Spiegel, Grazing Incidence Spiegel) umfassen.

Die Beleuchtungsoptik 4 hat bei der Ausführung, die in der Fig. 1 gezeigt ist, nach dem Kollektor 17 genau drei Spiegel, nämlich den Umlenkspiegel 19, den Feldfacettenspiegel 20 und den Pupillenfacettenspiegel 22.

Bei einer weiteren Ausführung der Beleuchtungsoptik 4 kann der Umlenkspiegel 19 auch entfallen, so dass die Beleuchtungsoptik 4 nach dem Kollektor 17 dann genau zwei Spiegel aufweisen kann, nämlich den ersten Facettenspiegel 20 und den zweiten Facettenspiegel 22.

Die Abbildung der ersten Facetten 21 mittels der zweiten Facetten 23 beziehungsweise mit den zweiten Facetten 23 und einer Übertragungsoptik in die Objektebene 6 ist regelmäßig nur eine näherungsweise Abbildung.

Die Projektionsoptik 10 umfasst eine Mehrzahl von Spiegeln Mi, welche gemäß ihrer Anordnung im Strahlengang der Projektionsbelichtungsanlage 1 durchnummeriert sind.

Bei dem in der Figur 1 dargestellten Beispiel umfasst die Projektionsoptik 10 sechs Spiegel M1 bis M6. Alternativen mit vier, acht, zehn, zwölf oder einer anderen Anzahl an Spiegeln Mi sind ebenso möglich. Der vorletzte Spiegel M5 und der letzte Spiegel M6 haben jeweils eine Durchtrittsöffnung für die Beleuchtungsstrahlung 16. Bei der Projektionsoptik 10 handelt es sich um eine doppelt obskurierte Optik. Die Projektionsoptik 10 hat eine bildseitige numerische Apertur, die größer ist als 0,5 und die auch größer sein kann als 0,6 und die beispielsweise 0,7 oder 0,75 betragen kann.

Reflexionsflächen der Spiegel Mi können als Freiformflächen ohne Rotationssymmetrieachse ausgeführt sein. Alternativ können die Reflexionsflächen der Spiegel Mi als asphärische Flächen mit genau einer Rotationssymmetrieachse der Reflexionsflächenform gestaltet sein. Die Spiegel Mi können, genauso wie die Spiegel der Beleuchtungsoptik 4, hoch reflektierende Beschichtungen für die Beleuchtungsstrahlung 16 aufweisen. Diese Beschichtungen können als Multilayer-Beschichtungen, insbesondere mit alternierenden Lagen aus Molybdän und Silizium, gestaltet sein.

Die Projektionsoptik 10 hat einen großen Objekt-Bildversatz in der y-Richtung zwischen einer y-Koordinate eines Zentrums des Objektfeldes 5 und einer y-Koordinate des Zentrums des Bildfeldes 11. Dieser Objekt-Bild-Versatz in der y-Richtung kann in etwa so groß sein wie ein z-Abstand zwischen der Objektebene 6 und der Bildebene 12.

Die Projektionsoptik 10 kann insbesondere anamorphotisch ausgebildet sein. Sie weist insbesondere unterschiedliche Abbildungsmaßstäbe βₓ, β_{y} in x- und y-Richtung auf. Die beiden Abbildungsmaßstäbe βₓ, β_{y} der Projektionsoptik 7 liegen bevorzugt bei (βₓ, β_{y}) = (+/- 0,25, /+-0,125). Ein positiver Abbildungsmaßstab β bedeutet eine Abbildung ohne Bildumkehr. Ein negatives Vorzeichen für den Abbildungsmaßstab β bedeutet eine Abbildung mit Bildumkehr.

Die Projektionsoptik 7 führt somit in x-Richtung, das heißt in Richtung senkrecht zur Scanrichtung, zu einer Verkleinerung im Verhältnis 4:1.

Die Projektionsoptik 10 führt in y-Richtung, das heißt in Scanrichtung, zu einer Verkleinerung von 8:1.

Andere Abbildungsmaßstäbe sind ebenso möglich. Auch vorzeichengleiche und absolut gleiche Abbildungsmaßstäbe in x- und y-Richtung, zum Beispiel mit Absolutwerten von 0,125 oder von 0,25, sind möglich.

Die Anzahl von Zwischenbildebenen in der x- und in der y-Richtung im Strahlengang zwischen dem Objektfeld 5 und dem Bildfeld 11 kann gleich sein oder kann, je nach Ausführung der Projektionsoptik 10, unterschiedlich sein. Beispiele für Projektionsoptiken mit unterschiedlichen Anzahlen derartiger Zwischenbilder in x- und y-Richtung sind bekannt aus der US 2018/0074303 A1.

Jeweils eine der Pupillenfacetten 23 ist genau einer der Feldfacetten 21 zur Ausbildung jeweils eines Beleuchtungskanals zur Ausleuchtung des Objektfeldes 5 zugeordnet. Es kann sich hierdurch insbesondere eine Beleuchtung nach dem Köhlerschen Prinzip ergeben. Das Fernfeld wird mit Hilfe der Feldfacetten 21 in eine Vielzahl an Objektfeldern 5 zerlegt. Die Feldfacetten 21 erzeugen eine Mehrzahl von Bildern des Zwischenfokus auf den diesen jeweils zugeordneten Pupillenfacetten 23.

Die Feldfacetten 21 werden jeweils von einer zugeordneten Pupillenfacette 23 einander überlagernd zur Ausleuchtung des Objektfeldes 5 auf das Retikel 7 abgebildet. Die Ausleuchtung des Objektfeldes 5 ist insbesondere möglichst homogen. Sie weist vorzugsweise einen Uniformitätsfehler von weniger als 2 % auf. Die Felduniformität kann über die Überlagerung unterschiedlicher Beleuchtungskanäle erreicht werden.

Durch eine Anordnung der Pupillenfacetten kann geometrisch die Ausleuchtung der Eintrittspupille der Projektionsoptik 10 definiert werden. Durch Auswahl der Beleuchtungskanäle, insbesondere der Teilmenge der Pupillenfacetten, die Licht führen, kann die Intensitätsverteilung in der Eintrittspupille der Projektionsoptik 10 eingestellt werden. Diese Intensitätsverteilung wird auch als Beleuchtungssetting bezeichnet.

Eine ebenfalls bevorzugte Pupillenuniformität im Bereich definiert ausgeleuchteter Abschnitte einer Beleuchtungspupille der Beleuchtungsoptik 4 kann durch eine Umverteilung der Beleuchtungskanäle erreicht werden.

Im Folgenden werden weitere Aspekte und Details der Ausleuchtung des Objektfeldes 5 sowie insbesondere der Eintrittspupille der Projektionsoptik 10 beschrieben.

Die Projektionsoptik 10 kann insbesondere eine homozentrische Eintrittspupille aufweisen. Diese kann zugänglich sein. Sie kann auch unzugänglich sein.

Die Eintrittspupille der Projektionsoptik 10 lässt sich regelmäßig mit dem Pupillenfacettenspiegel 22 nicht exakt ausleuchten. Bei einer Abbildung der Projektionsoptik 10, welche das Zentrum des Pupillenfacettenspiegels 22 telezentrisch auf den Wafer 13 abbildet, schneiden sich die Aperturstrahlen oftmals nicht in einem einzigen Punkt. Es lässt sich jedoch eine Fläche finden, in welcher der paarweise bestimmte Abstand der Aperturstrahlen minimal wird. Diese Fläche stellt die Eintrittspupille oder eine zu ihr konjugierte Fläche im Ortsraum dar. Insbesondere zeigt diese Fläche eine endliche Krümmung.

Es kann sein, dass die Projektionsoptik 10 unterschiedliche Lagen der Eintrittspupille für den tangentialen und für den sagittalen Strahlengang aufweist. In diesem Fall sollte ein abbildendes Element, insbesondere ein optisches Bauelement der Übertragungsoptik, zwischen dem zweiten Facettenspiegel 22 und dem Retikel 7 bereitgestellt werden. Mit Hilfe dieses optischen Elements kann die unterschiedliche Lage der tangentialen Eintrittspupille und der sagittalen Eintrittspupille berücksichtigt werden.

Bei der in der Figur 1 dargestellten Anordnung der Komponenten der Beleuchtungsoptik 4 ist der Pupillenfacettenspiegel 22 in einer zur Eintrittspupille der Projektionsoptik 10 konjugierten Fläche angeordnet. Der Feldfacettenspiegel 20 ist verkippt zur Objektebene 5 angeordnet. Der erste Facettenspiegel 20 ist verkippt zu einer Anordnungsebene angeordnet, die vom Umlenkspiegel 19 definiert ist.

Der erste Facettenspiegel 20 ist verkippt zu einer Anordnungsebene angeordnet, die vom zweiten Facettenspiegel 22 definiert ist.

Die den Beleuchtungsstrahlengang definierenden Spiegelmodule des Beleuchtungssystems 1 sind von einer geringe Mengen Wasserstoff (H₂) enthaltenden Unterdruck-Atmosphäre umgeben in einer evakuierbaren Kammer im Inneren eines Gehäuses untergebracht. Die Kammer kommuniziert über eine Fluidleitung, in der ein Absperrventil untergebracht ist, mit einer Vakuumpumpe. Der Betriebsdruck in der evakuierbaren Kammer beträgt einige Pascal. Der Partialdruck von Wasserstoff (H₂) kann z.B. im Bereich von 2 Pa bis 20 Pa liegen. Alle anderen Partialdrücke liegen üblicherweise im ppm-Bereich.

Der erste Facettenspiegel (Feldfacettenspiegel) 20 und der zweite Facettenspiegel (Pupillenfacettenspiegel) 22 sind Beispiele für steuerbare EUV-Mehrfachspiegelanordnungen in Form von Multi-Mirror-Arrays (MMA).

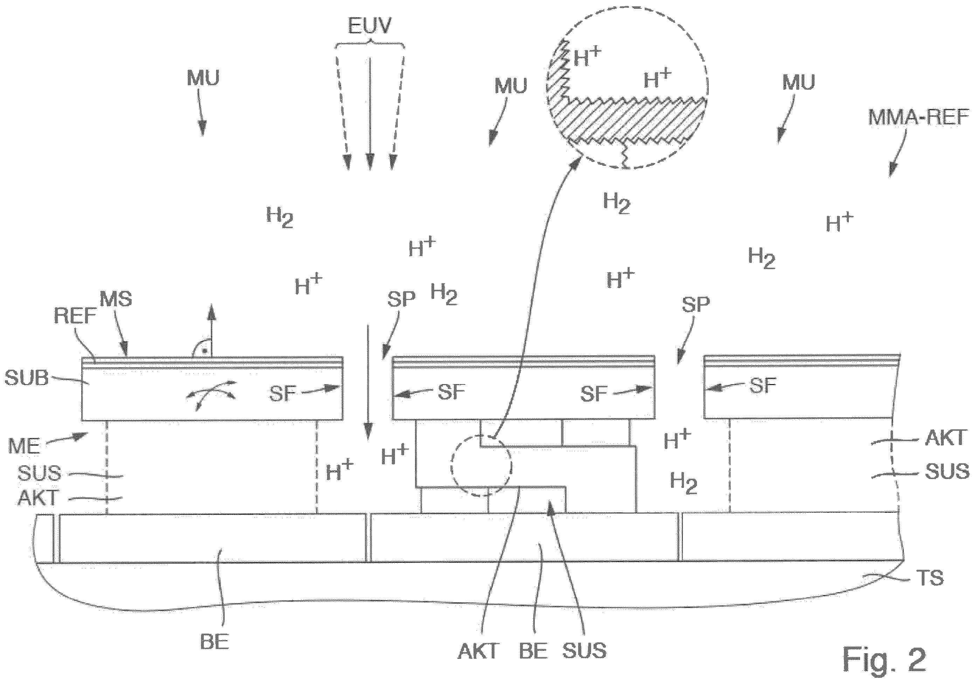

Anhand von Fig. 2 wird eine beispielhafte Konstruktion einer solchen EUV-Mehrfachspiegelanordnung des Standes der Technik (Referenzsystem mit Bezugszeichen MMA-REF) erläutert.

Auf einer formstabilen Trägerstruktur TS in Form einer Grundplatte ist eine große Anzahl von Spiegeleinheiten MU angeordnet, die an der Trägerstruktur TS in einer matrixartigen zweidimensionalen Rasteranordnung in Reihen und Spalten nebeneinander angeordnet sind.

Jede der Spiegeleinheiten MU hat ein auf der Trägerstruktur befestigtes Basiselement BE und ein Spiegelelement ME, welches mittels eines flexiblen Aufhängungssystems SUS gegenüber dem Basiselement BE individuell beweglich gelagert ist. Im Beispielsfall können die Spiegelelemente ME individuell gegenüber dem zugehörigen Basiselement BE in zwei rotatorischen Freiheitsgraden verkippt werden. Jedes Spiegelelement ME hat ein im Wesentlichen plattenförmiges Spiegelsubstrat SUB, das an seiner dem Basiselement BE abgewandten Vorderfläche eine Reflexionsbeschichtung REF trägt, die eine für EUV-Strahlung reflektierende Spiegelfläche MS bildet. Die Reflexionsbeschichtung hat eine Viellagenstruktur (Multilayer) mit mehreren Paaren von abwechselnd hochbrechendem und relativ dazu niedrigbrechendem Schichtmaterial (zum Beispiel Mo-Si), ggf. mit Zwischenschichten. Die Vorderfläche bzw. die dazu korrespondierende Spiegelfläche MS kann eben oder leicht konkav oder konvex gekrümmt sein. Gekrümmte Flächen können sphärisch oder asphärisch gekrümmt sein.

Die Spiegeleinheiten MU sind so nahe beieinander angebracht, dass die Spiegelflächen MS im Wesentlichen flächenfüllend nebeneinander angeordnet sind. Dies bedeutet insbesondere, dass das Verhältnis der Summe der Spiegelflächen der einzelnen Spiegelelemente ME zu der mit Spiegeleinheiten belegten Gesamtfläche des Spiegel-Arrays, die sogenannte IntegrationsDichte, relativ hoch ist, beispielsweise größer als 0,7 oder größer als 0,8 oder größer als 0,9. Eine vollständige Flächenfüllung ist nicht möglich, da zwischen unmittelbar benachbarten Spiegelelementen ME jeweils ein durch Seitenflächen SF der angrenzenden Spiegelsubstrate SUB begrenzter Spalt SP verbleibt, durch den eine kollisionsfreie Relativbewegung der benachbarten Spiegelelemente gegeneinander sichergestellt ist. Die Spaltbreiten zwischen einander zugewandten Seitenflächen unmittelbar benachbarter Spiegelsubstrate können beispielsweise in einer Größenordnung von einigen zehn Mikrometern liegen, beispielsweise im Bereich zwischen 20 µm und 100 µm.

In jeder Spiegeleinheit MU sind zwischen dem Basiselement BE und dem Spiegelelement ME Komponenten eines federelastischen Aufhängungssystems SUS angeordnet, das das Spiegelelement ME und das Basiselement BE strukturell verbindet, eine bewegliche Lagerung des Spiegelelements gegenüber dem Basiselement mit definierten Freiheitsgraden schafft und Rückstellkräfte bereitstellt, die dazu führen, dass sich ein Spiegelelement in Abwesenheit von Aktuatorkräften selbsttätig in eine Nullstellung ohne Verkippung bringt. Außerdem sind (nicht näher dargestellte) Komponenten eines Aktuatorsystems zur Erzeugung von Bewegungen des Spiegelelements relativ zum Basiselement in Reaktion auf den Empfang von Steuersignalen der Steuereinrichtung im Zwischenraum zwischen dem Spiegelsubstrat und dem Basiselement angeordnet. Diese können in die Struktur des Aufhängungssystems integriert sein, z.B. in Form von Abschnitten, die in Reaktion auf Steuersignale längenveränderlich und/oder biegsam sind. Weiterhin sind nicht dargestellte Komponenten von z.B. kapazitiven Positionssensoren vorhanden, mit denen die aktuelle Relativposition des Spiegelelements gegenüber dem Basiselement erfasst und entsprechende Signale an die Steuereinheit gegeben werden können. Somit ist eine Regelung der individuellen Kippwinkel der Spiegelsubstrate gegenüber der Trägerstruktur gewährleistet. Die kippbaren Spiegelelemente können z.B. in einem Verlagerungsbereich (range) von ± 50 mrad, insbesondere ± 100 mrad oder mehr um die Nullstellung verkippt werden, Einstellgenauigkeiten können z.B. kleiner als 0,2 mrad, insbesondere kleiner als 0,1 mrad sein.

Hohe Integrationsdichten lassen sich unter anderem dadurch erreichen, dass die Spiegelanordnungen unter Nutzung von Technologien aus dem Bereich der Herstellung von mikro-elektro-mechanischen Systemen (MEMS) hergestellt werden. Bei dem Beispiel von Fig. 2 sind wenigstens das Basiselement BE, das Aufhängungssystem SUS, das Aktuatorsystem und die Positionssensorik als MEMS-Struktur ausgebildet. MEMS-Strukturen werden heutzutage meist aus Silizium oder Silizium-Verbindungen hergestellt. Die DE 10 2015 204 874 A1 (entsprechend US 2017/363861 A1) beschreibt EUV-Mehrfachspiegelanordnungen mit MEMS-Strukturen aus Silizium oder einer Silizium-Verbindung, die als Beispiel für konventionelle EUV-Mehrfachspiegelanordnungen dienen können.

**Fig. 2** **veranschaulicht** schematisch einige Probleme, die zu einer vorzeitigen Degradation der Funktionalitäten von EUV-Mehrfachspiegelanordnungen führen können, insbesondere solchen mit MEMS-Strukturen. Wie erwähnt, werden die Mehrfachspiegelsysteme in weitgehend evakuierten Kammern genutzt, wobei in der Regel geringe Partialdrücke an Wasserstoff (H₂) vorhanden sind. Die energiereiche EUV-Strahlung im Beleuchtungsstrahlengang (Pfeile EUV) verursacht in erheblichem Ausmaß eine Ionisierung der H₂-Moleküle in positiv geladene Wasserstoff-Ionen (H₃⁺, H⁺) und Elektronen. Dadurch entsteht im durchstrahlten Bereich ein Wasserstoff-Ionen enthaltendes Plasma. Hohe Wasserstoff-Ionen-Konzentrationen können im bestrahlten Bereich vor den Spiegelflächen, also auf der der Trägerstruktur TS abgewandten Seite der Mehrfachspiegelanordnung, generiert werden. EUV-Strahlung kann jedoch auch durch die Spalte SP hindurch auch in den Zwischenraum ZR zwischen dem Spiegelsubstrat SUB und der Trägerstruktur TS gelangen und dort Wasserstoff-Ionen generieren.

Das durch EUV-Strahlung induzierte Plasma mit Wasserstoff-Ionen wirkt ätzend auf die mechanischen Komponenten der EUV-Mehrfachspiegelanordnung, insbesondere wenn diese aus Silizium oder einer Silizium-Verbindung bestehen. Dadurch werden die dem Plasma ausgesetzten Oberflächen durch Materialabtrag angegriffen, wie das Detail in Fig. 2 veranschaulicht. Durch den Ätzangriff können auch Silizium-Verbindungen freigesetzt werden, die sich an anderer Stelle in der Struktur wieder ablagern können. Die Strukturveränderungen durch Materialabtrag mittels Ätzen sowie daraus folgende Ablagerungen können die MEMS-Funktionalität beeinträchtigen. Ablagerungen, die sich auf den Spiegelflächen MS bilden, können zudem die Reflektivität reduzieren und dadurch die Transmission des Beleuchtungssystems vermindern.

Im Hinblick auf diese Problematik sind Ausführungsbeispiele erfindungsgemäßer EUV-Mehrfachspiegelanordnungen mit Ätzschutzstrukturen eines Ätzschutzsystems ausgestattet, das speziell dazu ausgelegt und angepasst ist, dem beschriebenen materialabtragenden und strukturverändernden Ätzangriff von durch EUV-Strahlung induziertem Wasserstoff-Plasma auf zwischen den Spiegelflächen und der Trägerstruktur angeordnete Komponenten der Spiegeleinheiten zu verhindern oder wenigstens im Vergleich zu Spiegeleinheiten ohne Ätzschutzsystem zu reduzieren. Das Ätzschutzsystem umfasst dabei Ätzschutzstrukturen, die sich an ausgewählten Komponenten der EUV-Mehrfachspiegelanordnung befinden bzw. an diesen Komponenten ausgebildet sind. Nachfolgend werden einige bevorzugte konstruktive Maßnahmen in Form von Ätzschutzstrukturen zur Verminderung oder Vermeidung von durch Ätzangriff bedingten Problemen beispielhaft erläutert.

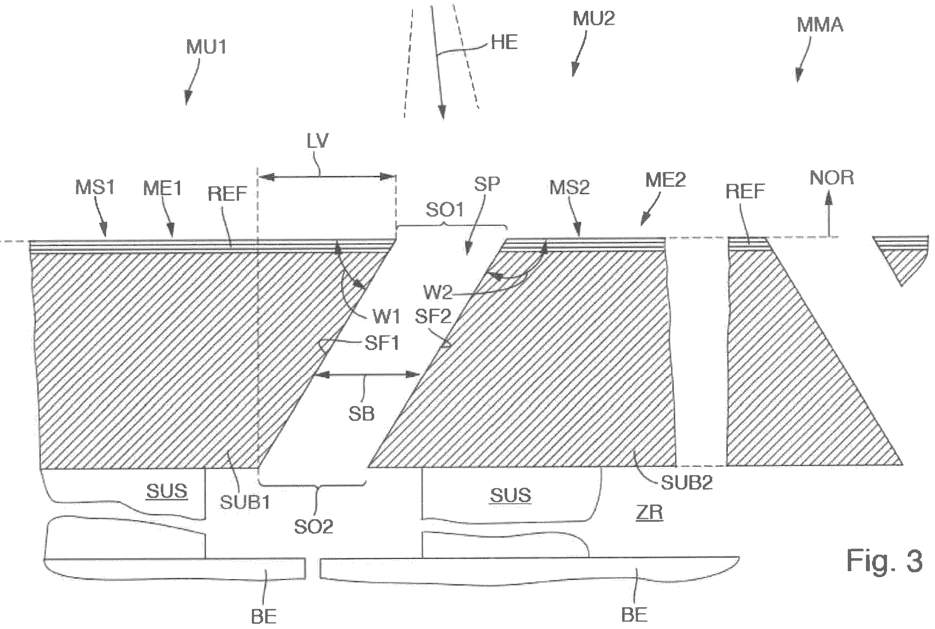

Die schematische und nicht maßstabsgetreue Fig. 3 zeigt einen senkrechten Schnitt durch einen Übergangsbereich zwischen zwei unmittelbar benachbarten Spiegeleinheiten MU1, MU2 eines MMA im Bereich der Spiegelsubstrate (erstes Spiegelsubstrat SUB1, zweites Spiegelsubstrat SUB2) zweier benachbarter Spiegelelemente ME1, ME2. Zwischen den Spiegelsubstraten liegt ein Spalt SP, der auf Seiten des ersten Spiegelsubstrats SUB1 von dessen erster Seitenfläche SF1 und auf Seiten des zweiten Spiegelsubstrats SUB2 von dessen nächstliegender zweiten Seitenfläche SF2 begrenzt wird. Die beiden Spiegelelemente befinden sich in ihrer Neutralstellung, sind also nicht gegeneinander verkippt. Die der einfallenden EUV-Strahlung EUV zugewandten Spiegelflächen MS1, MS2 definieren gemeinsam mit den Spiegelflächen der anderen Spiegelelemente eine Gesamtspiegelfläche, deren globale Flächennormale NOR schräg zur Haupt-Einfallsrichtung der eintreffenden EUV-Strahlung verläuft. Im realen Fall stammt die eintreffende EUV-Strahlung aus einem Einfallswinkelbereich, der sich beispielsweise um ± 5° oder ± 10° um diese Haupt-Einfallsrichtung erstreckt.

Die Mehrfachspiegelanordnung MMA kann bezüglich den Grundaufbaus dem Beispiel aus Fig. 2 entsprechen, auf die dortige Beschreibung wird insoweit verwiesen. Abweichend von dem in Fig. 2 angegebenen Stand der Technik verlaufen jedoch die Seitenflächen SF1, SF2 an den Randbereichen der Spiegelsubstrate SUB1, SUB2 nicht senkrecht zur jeweiligen Spiegelfläche MS1, MS2, sondern in einem von 90° signifikant abweichenden Winkel schräg dazu. Konkret schließt die erste Seitenfläche SF1 mit der zugeordneten Spiegelfläche MS1 einen spitzen Winkel W1 von weniger als 90° ein, wobei W1 beispielsweise im Bereich von 50° bis 80° liegen kann. Die unmittelbar gegenüberliegende zweite Seitenfläche SF2 schließt mit ihrer zugeordneten Spiegelfläche MS2 einen stumpfen Winkel W2 ein, der beispielsweise in der Größenordnung von 100° bis 130° liegen kann.

Im Beispiel sind die Absolutwerte der Abweichungswinkel von 90° auf beiden Seiten die gleichen und die Seitenflächen sind eben. Die Seitenflächen SF1, SF2 begrenzen eine Spalt SP, der schräg zu den angrenzenden Spiegelflächen MS1, MS2 und dementsprechend auch schräg gegenüber der Haupt-Einfallsrichtung HE der EUV-Strahlung verläuft. Der Spalt SP hat eine Spaltbreite SB, die an jeder Stelle längs des Spalts SP der lichten Weite zwischen den Seitenflächen gemessen in einer Ebene senkrecht zur globalen Spiegelnormale NOR entspricht.

Der Spalt SP verläuft in Tiefenrichtung (parallel zur Spiegelnormalen NOR) zwischen einer eintrittsseitigen ersten Spaltöffnung SO1 im Bereich der Reflexionsbeschichtungen REF und einer zweiten Spaltöffnung SO2 an der gegenüberliegenden Rückseite der Spiegelsubstrate und damit an der den Basiselementen zugewandten Seite. Befinden sich die Spiegelelemente in ihrer Neutralstellung (wie in Fig. 3 gezeigt), ist die Spaltbreite SB zwischen der ersten Spaltöffnung SO1 und der zweiten Spaltöffnung SO2 im Wesentlichen konstant, bei relativer Verkippung stellt sich dann eine in Tiefenrichtung variierende Spaltbreite ein.

Aufgrund der schrägen Orientierung des Spalts SP ergibt sich zwischen der ersten Spaltöffnung SO1 und der zweiten Spaltöffnung SO2 in derjenigen Richtung, in der die Spaltbreite SB gemessen wird, ein lateraler Versatz LV, der z.B. zwischen den an der Seite des ersten Spiegelsubstrats SUB2 liegenden Enden der Spaltöffnungen gemessen werden kann. Der laterale Versatz LV kann der Spaltbreite entsprechen, ist aber im Beispielsfall größer als die Spaltbreite SB, beispielsweise um mindestens 10 % oder um mindestens 20 % oder um mindestens 30 % oder mehr. Dies hat zur Folge, dass EUV-Strahlung, die in Haupt-Einfallsrichtung HE auf die Spiegelelemente einfällt, komplett durch die Spiegelsubstrate SUB1, SUB2 blockiert wird, so dass in dieser Einfallsrichtung keine EUV-Strahlung in den Zwischenraum ZR zwischen den Spiegelsubstraten SUB und den Basiselementen BE gelangen kann. Genauer gesagt wird die einfallende EUV-Strahlung am Spalt SP nur auf den oberen Teil der Seitenfläche SF2 des zweiten Substrats fallen und kann dort absorbiert werden.

Im Beispielsfall ist der laterale Versatz so bemessen, dass keine EUV-Strahlung aus einem Einfallswinkelbereich von ± 20° um die Haupt-Einfallsrichtung HE direkt durch den Spalt hindurch in den Zwischenraum ZR hinter den Spiegelsubstraten gelangen kann. Durch die schräge Anordnung des Spalts wird der Spalt deshalb zu einer Strahlungsfalle, die eine direkte Einstrahlung von EUV-Strahlung in den Zwischenraum hinter den Spiegelsubstraten verhindert.

Diese besondere Formgebung der Randbereiche der Spiegelsubstrate schafft in die Spiegelsubstrate integrierte Ätzschutzstrukturen und führt im Ergebnis zu einer wesentlichen Verringerung der Ätzrate an den hinter den Spiegelsubstraten SUB1, SUB2 etc. liegenden Komponenten, da aufgrund der fehlenden Einstrahlung von energiereicher EUV-Strahlung in diesem Zwischenraum keine Wasserstoff-Ionen generiert werden. Ein geringfügiger Ätzangriff kann ggf. durch Wasserstoff-Ionen verursacht werden, die im Bereich vor den Spiegelflächen MS der Spiegelelemente entstehen und aufgrund von Diffusion ihren Weg durch die Spalte SP finden.

Die Schrägstellung des Spalts ist im Übrigen so bemessen, dass bei sämtlichen Kippwinkeln der angrenzenden Spiegelsubstrate SUB1, SUB2 im Bereich ihrer jeweiligen zulässigen Kippbereiche eine vollständige Blockierung einer Direkteinstrahlung von EUV-Strahlung in den Bereich hinter die Spiegelsubstrate gegeben ist. Die Winkel W1, W2 bzw. die Schrägstellung des Spalts kann lokal an eine dort vorherrschende Einfallsrichtung angepasst sein.

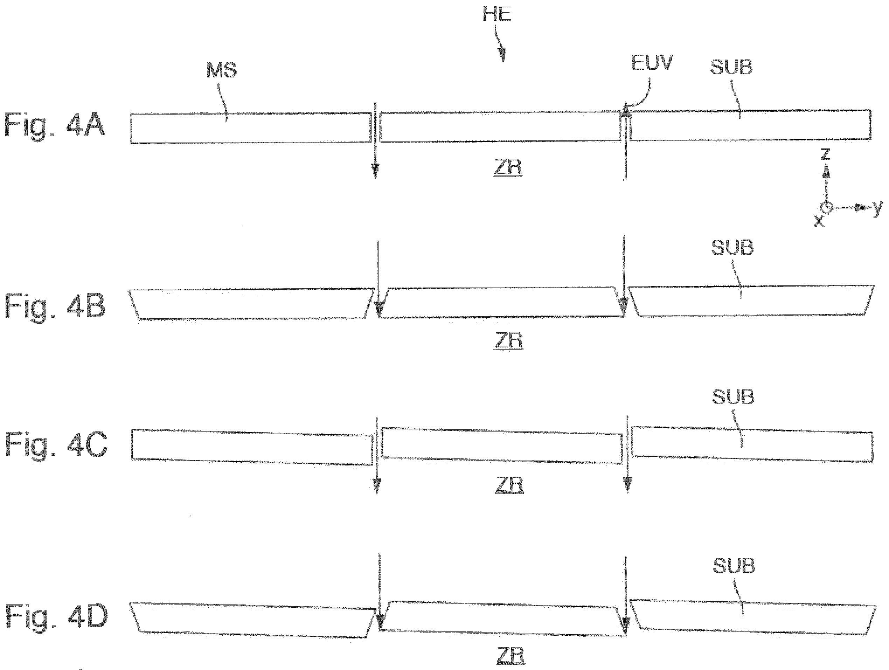

Die schematischen Fig. 4A bis 4D veranschaulichen übersichtlich den abschirmenden Effekt schräggestellter Spalte im Vergleich zu senkrecht verlaufenden (nicht schräggestellten) Spalten des Stands der Technik. EUV-Strahlung (Pfeile) fällt von der Strahlungseintrittsseite (in der Figur oben) parallel zur Haupt-Einfallsrichtung HE ein, die parallel zur z-Achse (Höhenachse) des trägerfesten Spiegelkoordinatensystems verläuft. Fig. 4A zeigt eine konventionelle Spiegelanordnung, deren benachbarte Spiegelelemente in ihrer Nullstellung sind. Die Spiegelflächen MS liegen dabei auf einer gemeinsamen Ebene und sind parallel zur x-y-Ebene des Spiegelkoordinatensystems ausgerichtet. Durch die Dicke der mit EUV bezeichneten Pfeile ist dargestellt, dass relativ viel EUV-Strahlung von der Vorderseite (Spiegelflächen MS) in den dahinterliegenden Zwischenraum ZR gelangt. Fig. 4C zeigt die konventionelle Anordnung, in der nun die benachbarten Spiegelelemente einheitlich um einige Grad aus der Nullstellung verkippt sind. Dadurch werden die effektiven Spaltbreiten zwar etwas kleiner, jedoch gelangt noch immer ein größerer Anteil der EUV-Strahlung hinter die Spiegelsubstrate SUB.

Die Fig. 4B und 4D zeigen vergleichbare Konstellationen mit Ausführungsbeispielen, bei denen die jeweils unmittelbar benachbarten Spiegelsubstrate SUB im Querschnitt eine trapezförmige Gestalt haben, deren kürzere Seiten abwechselnd auf der Lichteintrittsseite und der Lichtaustrittsseite liegen, so dass sich zwischen den unmittelbar benachbarten Spiegelsubstraten schräg zu den Spiegelflächen verlaufende Spalte SP ergeben. Durch die reduzierte Dicke der Strahlungspfeile EUV ist angedeutet, dass dadurch ein erheblicher Anteil der in Normalenrichtung (z-Richtung) auftreffenden EUV-Strahlung vom Durchtritt in den Zwischenraum ZR hinter den Spiegelsubstraten blockiert wird, wobei gegebenenfalls eine komplette Abschirmung erreicht werden kann. Wie Fig. 4D zeigt, ist die Abschirmungswirkung auch dann vorhanden, wenn die Spiegelelemente jeweils einheitlich leicht gegenüber der Nullstellung verkippt sind. Es kann sein, dass sich dadurch bestimmte Spalte ungünstig vergrößern. Bei Bedarf können dadurch verursachte Nachteile mit weiteren Maßnahmen kompensiert werden.

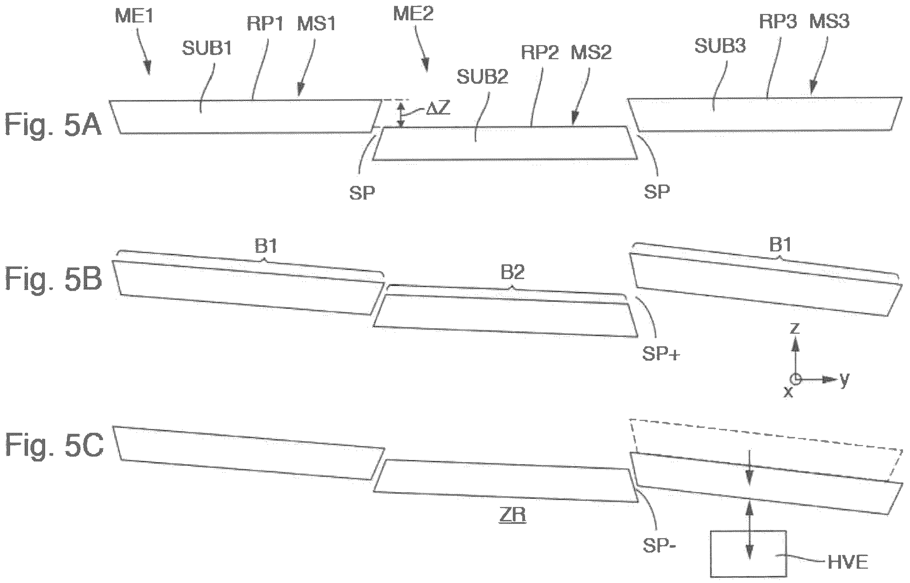

Anhand der schematischen Fig. 5A bis 5C werden Ausführungsbeispiele erläutert, bei denen ein Beitrag für eine bessere Abschirmung von EUV-Strahlung dadurch erreicht wird, dass unmittelbar benachbarte Spiegelelemente permanent oder zeitweise in der Höhe zueinander versetzt angeordnet sind. Als Höhenrichtung wird hier die z-Richtung des Spiegelkoordinatensystems bezeichnet, die mehr oder weniger exakt parallel zur Haupt-Einfallsrichtung der EUV-Strahlung ausgerichtet ist. Fig. 5A zeigt schematisch die Spiegelsubstrate SUB1, SUB2, SUB3 dreier unmittelbar nebeneinanderliegender Spiegelelemente ME1, ME2 und ME3, die jeweils gemessen in der Richtung (y-Richtung), in der sie nebeneinanderliegen, im Bereich ihrer Spiegelflächen MS1, MS2, MS3 abwechselnd zwei unterschiedliche Breiten haben, nämlich B1 und B2. Bei den außenliegenden Spiegelelementen ME1 und ME3 sind die einander zugewandten schräggestellten Seitenflächen so orientiert, dass die der Trägerstruktur (unten) zugewandte Substratrückseite schmaler ist als die Spiegelseite. Beim dazwischenliegenden Spiegelelement ME2 ist es umgekehrt, hier ist die Spiegelfläche in Breitenrichtung schmaler als die Substratrückseite. Die Spiegelsubstrate sind also abwechselnd in unterschiedlicher Orientierung ihrer breiteren und schmaleren Seiten angeordnet.

Diejenigen Spiegelelemente ME1, ME3, deren Spiegelfläche in der Breitenrichtung größer ist als die Substratrückseite, sind in Höhenrichtung gegenüber den anders orientierten Spiegelsubstraten zur Lichteintrittsseite höhenversetzt. Der Höhenversatz Δz kann als in Höhenrichtung gemessener Abstand zwischen einem durch die erste Spiegelfläche MS1 definierten Referenzpunkt RP1 am geometrischen Mittelpunkt der Spiegelfläche und dem entsprechenden, durch die unmittelbar benachbarte zweite Spiegelfläche MS2 definierten Referenzpunkt RP2 definiert werden. Der Höhenversatz ist in der Regel kleiner als die in Höhenrichtung gemessene Dicke des Spiegelsubstrats und kann beispielsweise zwischen 20 % und 80 % dieser Dicke liegen. Der Höhenversatz liegt in identischer oder ähnlicher Größe auch im Bereich des zwischen den Spiegelelementen liegenden Spalts SP vor. In Fig. 5A ist erkennbar, dass bei in Nullstellung befindlichen Spiegelelementen eine vollständige Blockierung der in Normalenrichtung eintretenden EUV-Strahlung erreicht wird. Der Höhenversatz ermöglicht eine Vergrößerung der kollisionsfrei verfügbaren Kippwinkelbereiche der Einzelspiegel, da die durch die jeweils anderen Spiegelelemente gebildeten Störkonturen weiter auseinanderliegen als bei einer Anordnung der Spiegelsubstrate auf einer gemeinsamen Höhe (vgl. Fig. 5B).

Der relative Höhenversatz ermöglicht zudem, gegenüber der zuvor dargestellten Ausführungsform, bei gleichbleibendem Kippwinkel eine stärker ausgeprägte Trapezform entlang des dargestellten Schnitts, wodurch der effektive laterale Versatz vergrößert wird.

Der relative Höhenversatz benachbarter Spiegelelemente kann fest vorgegeben sein. Vorzugsweise sind die Spiegelelemente dann abwechselnd in zwei unterschiedlichen Höhen angeordnet, wobei jeweils zwischen zwei Spiegelsubstraten einer gemeinsamen Höhenposition ein Spiegelsubstrat der anderen Höhenposition liegt. Es werden also alternierend zwei Höhenniveaus bereitgestellt. Der relative Höhenversatz kann auch an den erwarteten (vom optischen Design definierten) Kipp-Range der benachbarten Spiegelelemente angepasst sein und damit weitere Höhenniveaus beinhalten.

Fig. 5C zeigt ein anderes Ausführungsbeispiel mit Höhenversatz benachbarter Spiegelsubstrate. Die Mehrfachspiegelanordnung des Ausführungsbeispiels von Fig. 5C ist mit einer steuerbaren Höhenverstelleinrichtung HVE zur reversiblen, stufenlosen Höhenverstellung einzelner Spiegelelemente gegenüber benachbarten Spiegelelementen in Reaktion auf Steuersignale ausgestattet. Damit kann u.a. ein Konzept umgesetzt werden, wonach die Höhenposition (Position in Höhenrichtung bzw. z-Richtung) in Abhängigkeit von der tatsächlichen Kippstellung und Höhenstellung benachbarter Spiegelsubstrate eingestellt wird. Dazu zeigt Fig. 5C die drei Spiegelsubstrate SUB1, SUB2, SUB3 in den gleichen Kippstellungen wie Fig. 5B. Während sich jedoch in Fig. 5B zwischen dem zweiten Spiegelsubstrat SUB2 und dem dritten Spiegelsubstrat SUB3 aufgrund der unterschiedlichen Kippwinkel ein relativ großer Spalt SP+ ergibt, ist in der Variante von Fig. 5C der dritte Spiegel mithilfe der Höhenverstelleinrichtung (siehe Doppelpfeil) zurückgezogen und damit näher an das Höhenniveau des unmittelbar benachbarten zweiten Spiegelelements ME2 gerückt. Dadurch wird der dazwischenliegende Spalt SP- so schmal, dass der dahinterliegende Zwischenraum vollständig gegen in Normalenrichtung eintretende EUV-Strahlung blockiert wird.

Die Verlagerungskomponenten von Spiegelelementen, die zusätzlich zu den durch Kippung entstehenden Verlagerungen vorgesehen sein können, können ausschließlich in Höhenrichtung verlaufen. Es ist jedoch auch möglich, die Aktorik so auszugestalten, dass Verlagerungen mit einer Kombination von Verlagerungen in Höhenrichtung und in dazu senkrechte Lateralrichtungen (y- und x-Richtung) möglich sind.

Es ist möglich, dass die komplette Spiegeleinheit (inklusive Basiselement) in Höhenrichtung verlagert wird, z.B. indem zwischen der Trägerstruktur und dem Basiselement eine Piezoschicht liegt, deren Dicke gesteuert verändert werden kann. Alternativ oder zusätzlich ist es möglich, die Höhenverstellung über die Aktuatorik der zwischen Basiselement und Spiegelsubstrat liegenden Teilen der MEMS-Struktur zu realisieren.

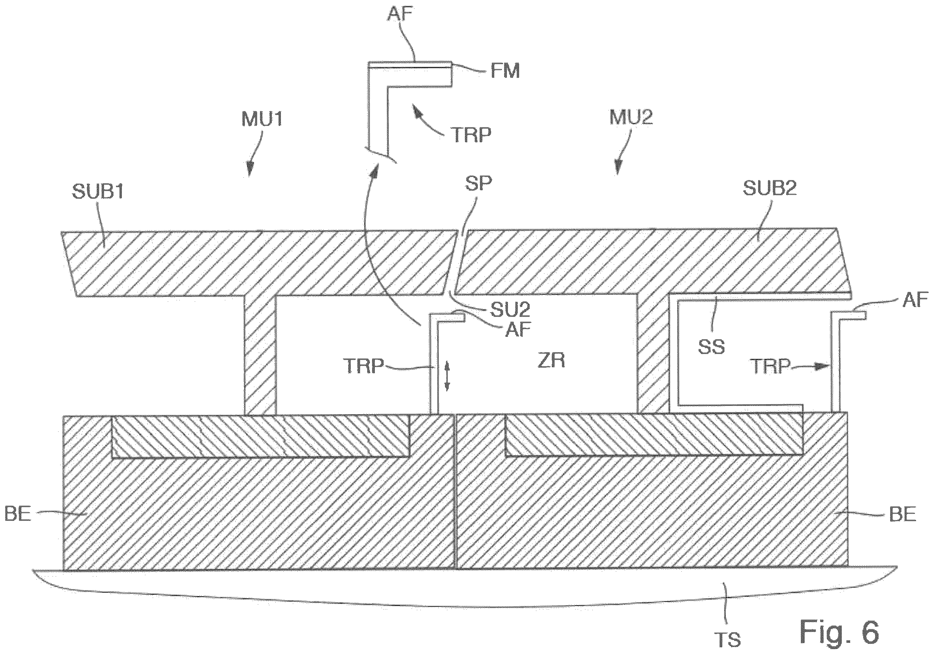

Die schematische Fig. 6 veranschaulicht weitere optionale Maßnahmen, um mithilfe von Ätzschutzstrukturen an den einzelnen Spiegeleinheiten die Einstrahlung von EUV-Strahlung in den Zwischenraum ZR zwischen den Spiegelsubstraten SUB und der Trägerstruktur TS zu vermindern oder zu vermeiden. Dargestellt sind zwei unmittelbar benachbarte Spiegeleinheiten MU1 und MU2, deren Spiegelsubstrate SUB1, SUB2 schräge Seitenflächen haben, so dass sich zwischen den Spiegelsubstraten ein schräggestellter Spalt SP ergibt. Zusätzlich ist an jeder Spiegeleinheit ein Abschnitt der MEMS-Struktur ausgebildet, der als Strahlungsfallenelement TRP wirkt. Ein Strahlungsfallenelement kann beispielsweise integral mit einem Basiselement BE bei der Strukturierung der Komponente erzeugt wird.

Die nur schematisch dargestellten Strahlungsfallenelemente TRP haben jeweils im Bereich unmittelbar hinter der trägerseitigen zweiten Spaltöffnung des Spalts SP eine parallel zur x-y-Ebene ausgerichtete Strahlungsauftrefffläche AF, die breiter ist als die trägerseitige Spaltöffnung SO2 ist und diese auf beiden Seiten etwas überragt. Die Strahlungsauftrefffläche erstreckt sich entlang des Spaltes, ist also in ihrer senkrecht zur Zeichnungsebene verlaufenden Längsrichtung vielfach länger als in Breitenrichtung. Der Höhenabstand zwischen der Strahlungsauftrefffläche AF und der Substratrückseite ist so bemessen, dass eine Verkippung der Spiegelsubstrate über ihren maximalen Kippwinkelbereich ohne Kollision mit dem Strahlungsfallenelement möglich ist. Ebenfalls ist es möglich, abschnittsweise die Strahlungsfallenelemente TRP in der Höhe an die aktuelle Kippstellung der darüberliegenden Spiegel anzupassen, um den effektiven Spalt kollisionsfrei zu minimieren.

Während die Grundstruktur des Strahlungsfallenelements aus dem Material des Basiselements bestehen kann (beispielsweise Silizium), kann die Strahlungsauftrefffläche durch eine entsprechende Beschichtung mit einem Funktionsmaterial FM besondere Eigenschaften aufweisen. Das Funktionsmaterial kann einerseits so ausgebildet sein, dass es für EUV-Strahlung absorbierend wirkt, so dass das Strahlungsfallenelement als EUV-Absorber fungiert. Alternativ oder zusätzlich kann das Funktionsmaterial auch so ausgebildet sein, dass es als Rekombinationskatalysator für die Wasserstoffionen und Wasserstoffatome wirkt, so dass eventuell durch den Spalt eindringende Wasserstoffionen dort zu Wasserstoffatomen und diese bevorzugt zu Wasserstoffmolekülen rekombinieren und damit unschädlich im Hinblick auf die Ätzgefahr werden. Es ist ersichtlich, dass solche Strahlungsfallenstrukturen auch eventuell durch die Spalte eindringende Kontaminationspartikel auffangen können und auch insoweit dem Schutz der dahinterliegenden Strukturen dienen.

Strahlungsfallenelemente können auch in Kombination mit konventionellen Mehrfachspiegelanordnungen (mit senkrechten Spalten) vorgesehen sein und dort als Ätzschutzelemente dienen.

In Fig. 6 ist durch einen Doppelpfeil eine optionale Ausführungsform dargestellt, bei der Strahlungsfallenelemente abschnittsweise in der Höhe verstellbar sind. Die Höheneinstellung des jeweiligen Strahlungsfallenelements kann in Abhängigkeit von den Kippstellungen und/oder Höhenstellungen benachbarter Spiegelelemente aktuiert werden, um bei jeder Kippstellung einen optimalen Abstand zum Spalt einzustellen. Zur Höhenverstellung kann z.B. ein Piezoaktor oder ein pneumatischer Aktor vorgesehen sein. Alternativ zur Anordnung eines Strahlungsfallenelements auf einem Basiselement ist auch eine Befestigung auf der Trägerstruktur in einem Zwischenraum zwischen benachbarten Basiselementen möglich.

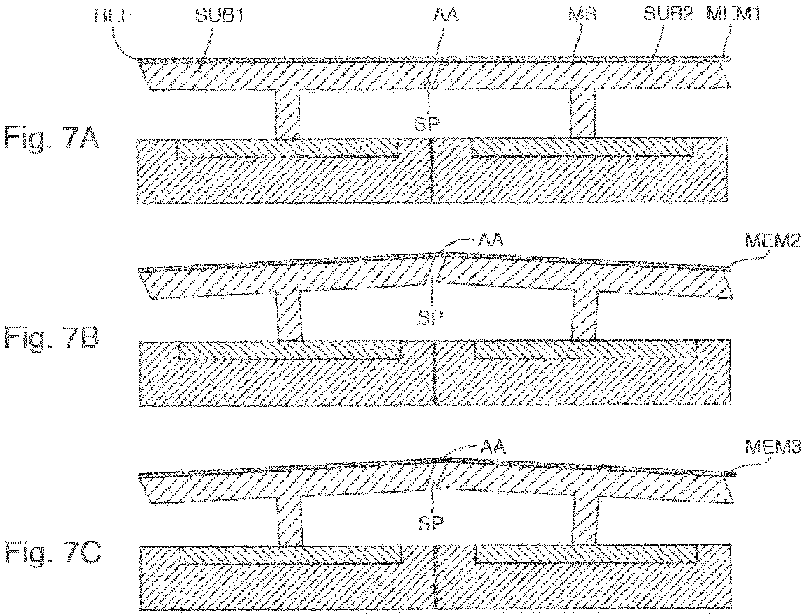

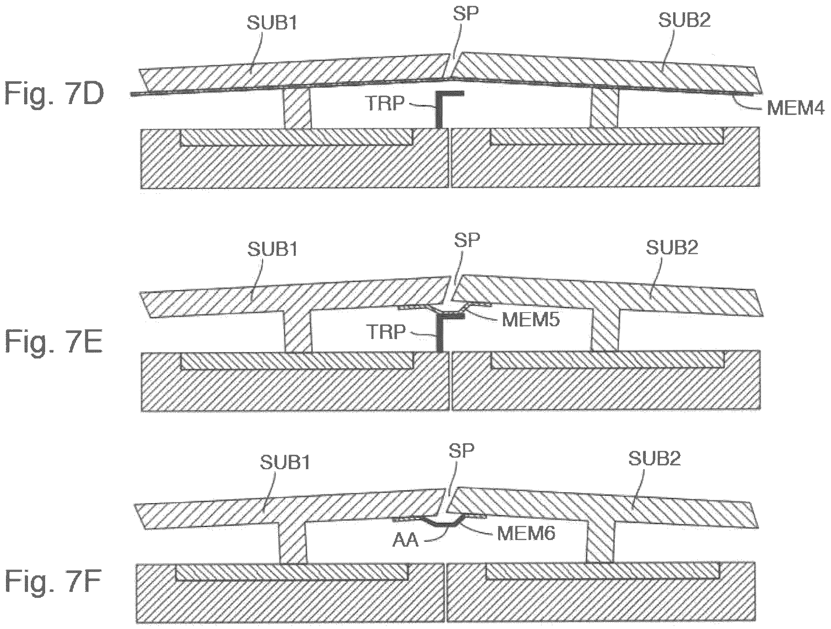

In den Fig. 7A bis 7F sind unterschiedliche Beispiele für Teile eines Ätzschutzsystems dargestellt, das Ätzschutzstrukturen in Form einer Schutzmembran MEM aufweist, die für jeden der abgedeckten Spalte einen Spaltabdeckabschnitt AA umfasst, der den jeweiligen Spalt überbrückt bzw. abdeckt. Der Spalt ist zwischen zwei unmittelbar benachbarten Spiegelsubstraten SUB1, SUB2 gebildet. Die Membran MEM bzw. der Spaltabdeckabschnitt AA wird von den Spiegelsubstraten SUB getragen und ist dazu an den Spiegelsubstraten befestigt, im Fall der Fig. 7A bis 7C z.B. jeweils an der mit Reflexionsbeschichtung versehenen Strahlungseintrittsseite (vgl. Fig. 7A bis 7C) oder an der Rückseite der Spiegelsubstrate (vgl. Fig. 7D bis 7F).

Bei der Schutzmembran MEM kann es sich um eine flexible und/oder begrenzt dehnbare Membran handeln, die auch die leichten Kippbewegungen der Spiegelelemente gegeneinander mitmachen bzw. eventuelle Dimensionsänderungen im Bereich des Spalts ausgleichen kann (vgl. Fig. 7B). Die Schutzmembran kann beispielsweise eine dünne Metallfolie und/oder eine dünne Polyimidfolie aufweisen oder durch derartige Folien gebildet sein.

Im Beispiel von Fig. 7A ist die Schutzmembran MEM1 so dünn und aus einem solchen Material, dass eine hohe Durchlässigkeit für EUV-Strahlung gegeben ist. Somit kann auch im Bereich des Strahlungsabdeckabschnitts AA EUV-Strahlung in den Spalt eindringen, wird jedoch dort aufgrund der Schrägstellung des Spalts weitgehend oder ganz blockiert. Die Membran schützt die dahinterliegende MEMS-Struktur dennoch vor Degradation durch Ätzen, da ein Eindringen von Wasserstoffionen enthaltendem Plasma durch den Spalt in den dahinterliegenden Zwischenraum durch die Membran völlig verhindert wird. Die Membran MEM1 kann großflächig die gleichen Transmissionseigenschaften haben. Dadurch kann erreicht werden, dass auch in den von der Membran bedeckten Spiegelflächen die Reflektivität nur geringfügig reduziert wird.

Es ist auch möglich, die Schutzmembran als lateral strukturierte Membran auszulegen, was hier im weitesten Sinne bedeutet, dass die Membran herstellungsbedingt Bereiche mit unterschiedlichen Eigenschaften gemäß einer vorgegebenen Struktur aufweist. Im Beispiel von Fig. 7C ist eine strukturierte Membran MEM3 an der reflektiven Seite der Spiegelelemente angebracht. Diese verläuft über die gesamten Spiegelflächen und überbrückt die dazwischenliegenden Spalte mit entsprechenden Spaltabdeckabschnitten AA. Die Schutzmembran ist so strukturiert, dass im Bereich der Spaltabdeckabschnitte AA die Membran eine wesentlich geringere EUV-Transmission besitzt als in denjenigen Bereichen, die im Bereich der Spiegelflächen liegen. Dadurch kann im Bereich des Spalts dieser gegen eintretende EUV-Strahlung wenigstens teilweise abgeschirmt werden, so dass nicht nur eindringende Kontaminationen und Plasma blockiert werden, sondern auch die eventuelle Entstehung neuer Wasserstoffionen im Zwischenbereich zwischen Spiegelsubstrat und Basiselement reduziert bzw. verhindert wird.

Der Nutzeffekt einer strukturierten Schutzmembran kann dadurch vergrößert werden, dass die Membran nach Aufbringen auf die die Membran tragenden Spiegelelemente in dem Bereich der Reflexionsbeschichtungen beseitigt oder durch Ätzen oder dergleichen so weit gedünnt wird, dass keine oder nur noch eine geringe reflektivitätsmindernde Wirkung eintritt. Im Bereich der Spaltabdeckabschnitte AA kann die Membran so weit verbleiben, dass ihre gegenüberliegenden Randbereiche an den an den Spalt angrenzenden Randbereichen der angrenzenden Spiegelsubstrate befestigt werden können.

In den Beispielen der Fig. 7A bis 7C ist eine Schutzmembran an der reflektiven Seite der Spiegelelemente, also an den Vorderseiten der Spiegelsubstrate, befestigt. Dies ist nicht zwingend. Ein Spaltabdeckabschnitt kann auch an der Rückseite der aneinander angrenzenden Spiegelsubstrate befestigt werden, so dass die zweite Spaltöffnung abgedeckt wird (vgl. Fig. 7D). Dann kann zwar noch kontaminierendes Material in den Bereich des Spalts eindringen, ein Eindringen in den dahinterliegenden Zwischenraum ist jedoch unterbunden. Auch die strahlungsblockierende Wirkung kann bei entsprechender Ausgestaltung des Spaltabdeckabschnitts erhalten bleiben. Die reflektive Fläche der Spiegelelemente ist dann frei von Membranteilen, was günstig zur Erzielung hoher Reflexionsgrade ist.

Bei der Variante in Fig. 7E ist eine Schutzmembran MEM5 zwischen der Rückseite des Spiegelsubstrats und einer Rückseite des Strahlungsfallenelements angeordnet. Die Schutzmembran ist hier einerseits an den Rückseiten der benachbarten Spiegelsubstrate SUB1, SUB2 und mit einem dazwischen liegenden Abschnitt an der Vorderseite des Strahlungsfallenelements TRP befestigt. Dieses ist in der Höhe beweglich gelagert. Werden die benachbarten Spiegelelemente gegeneinander verkippt, so kann durch die Schichtspannung der Schutzmembran MEM5 zwischen der Spiegeleinheit und dem Strahlungsfallenelement eine kippstellungsabhängige Höhenverstellung des Strahlungsfallenelements TRP erreicht werden, indem dieses in z-Richtung mitgenommen wird.

Fig. 7F zeigt eine Variante der Anordnung aus Fig. 7E ohne Strahlungsfallenelement. Die Schutzmembran MEM6 ist hier an den Rückseiten der benachbarten Spiegelsubstrate SUB1, SUB2 befestigt und überbrückt den Spaltbereich mit einen leicht durchhängenden absorbierenden Abschnitt AA, der durch den Spalt hindurchtretende EUV-Strahlung absorbiert. Ähnlich einer elastischen Dichtung kann die Schutzmembran bei Verkippung der Spiegelsubstrate eine eventuelle Spaltvergrößerung ausgleichen, ohne die Befestigungsstellen unter Zugspannung zu setzen oder der Verkippung entgegenzuwirken.

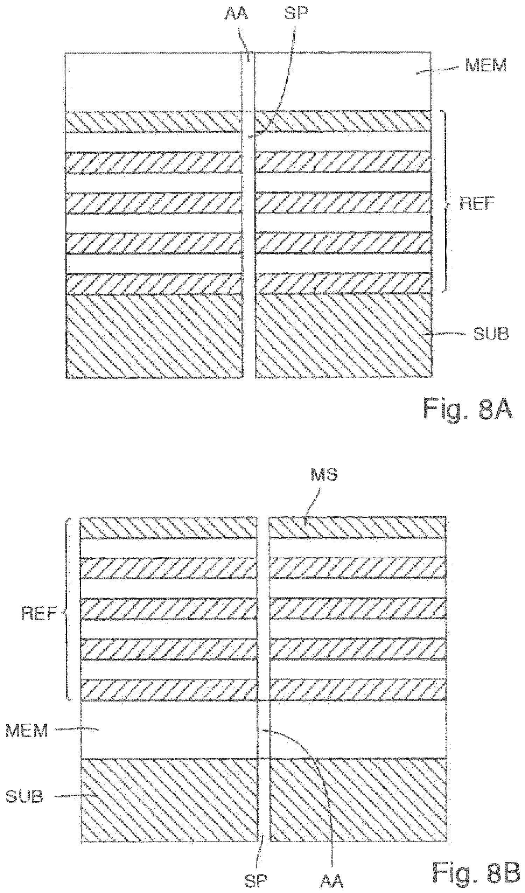

Die schematischen Fig. 8A und 8B zeigen jeweils schematische Schnitte durch benachbarte Spiegelsubstrate SUB im Bereich eines zwischenliegenden Spalts SP im Bereich der Reflexionsbeschichtung REF und der Schutzmembran MEM. Fig. 8A zeigt dabei vergrößert diejenige Anordnung der Schutzmembran, die auch in den Beispielen von Fig. 7A bis 7C gewählt ist. Dabei befindet sich auf der Vorderseite des Spiegelsubstrats SUB die Schichtenfolge der Reflexionsbeschichtung REF. Auf deren freier Außenfläche ist dann die stabilisierte Schutzmembran MEM aufgebracht, die mit ihrem Spaltabdeckungsabschnitt AA den Spalt SP überdeckt.

Fig. 8B zeigt eine Alternative einer Ätzschutzstruktur mit Schutzmembran MEM. Die benachbarten Spiegelsubstrate SUB1, SUB2 begrenzen den zwischenliegenden Spalt SP. Unmittelbar auf die freie Oberfläche der Spiegelsubstrate (oder unter Zwischenschaltung von einer oder mehreren Funktionsschichten) ist zunächst die Schutzmembran MEM aufgebracht. Auf die Außenseite der Schutzmembran MEM ist dann die Schichtenfolge der Mehrlagen-Reflexionsbeschichtung REF aufgebracht, so dass die Spiegelfläche MS durch die freie Oberfläche der Reflexionsbeschichtung REF gebildet wird. Auch hier überdeckt die Schutzmembran MEM mit ihrem Spaltabdeckabschnitt AA den Spalt, jedoch wird die reflektierende Wirkung der Reflexionsbeschichtung nicht durch die Schutzmembran beeinträchtigt. Somit muss bei der Auswahl und Auslegung der Schutzmembran nicht auf besonders geringe EUV-Transmissionen geachtet werden. Stattdessen kann die EUV-Transmission relativ gering sein, so dass die strahlungsblockierende Wirkung groß ist. Die Reflektivität der Reflexionsbeschichtung wird durch derartige Ätzschutzstrukturen nicht beeinträchtigt.

Bei manchen Ausführungsformen weist das Ätzschutzsystem nur einen der genannten Typen von Ätzschutzstrukturen auf. Beispielsweise kann es ausreichen, wenn lediglich die schräggestellten Spalte vorgesehen werden. Häufig werden jedoch Ätzschutzsysteme vorteilhaft sein, bei denen zwei oder mehr der genannten Ätzschutzstrukturen kombiniert sind. Beispielsweise kann die Höhenverstellung einzelner Spiegelsubstrate in Kombination mit den Strahlungsfallenstrukturen und/oder in Kombination mit einer Schutzmembran vorgesehen sein.

Es können weitere Maßnahmen zur Vermeidung von Degradation durch Ätzangriffe an funktionalen Strukturen der Spiegeleinheiten vorgesehen sein. Beispielsweise kann vorgesehen sein, die MEMS-Strukturen zumindest in einigen oder allen einem Ätzangriff bevorzugt ausgesetzten Oberflächenbereichen aus einem Material zu fertigen, das gegenüber Ätzangriff durch Wasserstoffionen deutlich beständiger ist als das für MEMS-Strukturen typischerweise verwendete Silizium. Beispielsweise können Ätzschutzschichten aus Aluminiumoxid oder Aluminium vorgesehen sein, z.B. auf der Rückseite und den Seitenwänden des Spiegelsubstrats, an dem Stößel, welcher das Spiegelsubstrat tragen kann, sowie an Teilen der Basiselemente. Beispiele solcher Ätzschutzschichten SS sind in Fig. 6 rechts schematisch gezeigt.

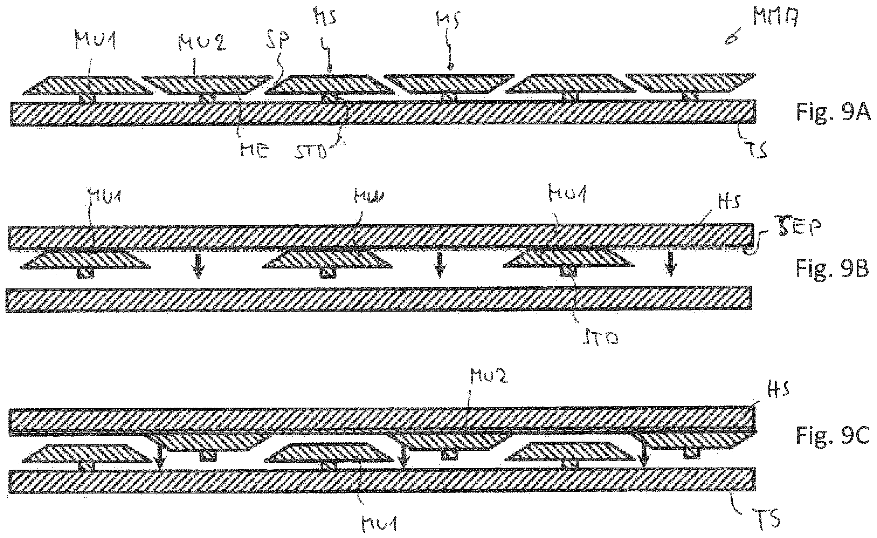

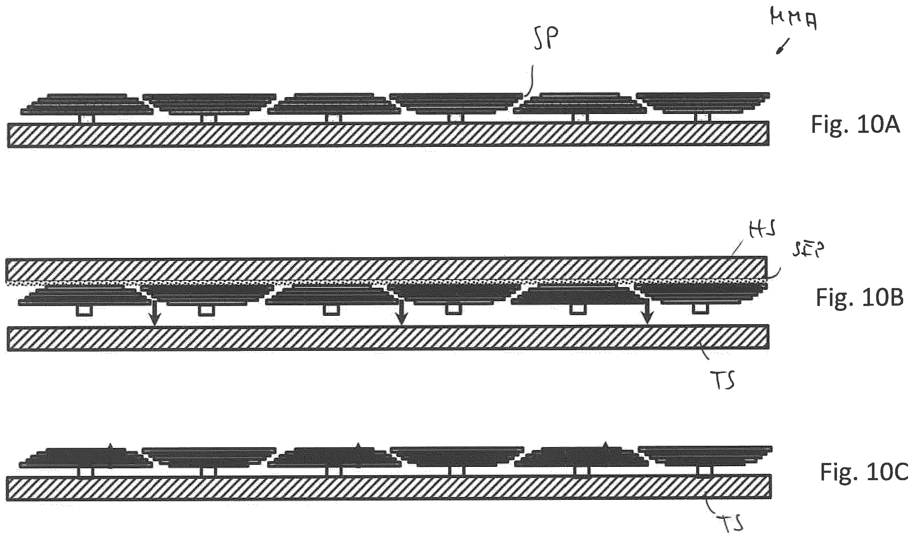

Anhand der Fig. 9A bis 9C und 10A bis 10C werden nun zwei Möglichkeiten zur Herstellung von Mehrfachspiegelanordnungen mit schräg gestellten Spalten zwischen benachbarten Spiegelelementen erläutert. Fig. 9A zeigt einen schematischen Schnitt durch eine fertige Mikrospiegelanordnung MMA entlang einer Reihe oder Spalte von Spiegeleinheiten, die auf einer Trägerstruktur TS in Form einer Silizium-Platte angebracht sind. Jede Spiegeleinheit hat ein Spiegelelement ME und einen mittig daran angebrachten soliden Ständer bzw. Fuß (post) STD. Die nur schematisch gezeigte Trägerstruktur TS weist die mechatronischen Teile auf. Dazu gehören u.a. die flexible Aufhängung, die Aktuatoren, ggf. Sensoren, z.B. Orientierungssensoren etc. Die Spiegelflächen MS sind an der der Trägerstruktur abgewandten Seite ausgebildet. Die Spiegelsubstrate haben in der gezeigten Querschnittsebene einen im Wesentlichen trapezförmigen Querschnitt, wobei die Trapeze alternierend orientiert sind in der Weise, dass jedes zweite Spiegelelement die gleiche Orientierung zwischen der schmaleren Seite und der breiteren Seite hat, so dass zwischen den Spiegelelementen die schrägen Spalte SP vorliegen.

Der beispielhafte Herstellprozess umfasst zwei Herstellungsschritte, wobei in jedem Herstellungsschritt eine Gruppe gleich orientierter Spiegeleinheiten MU nebst Aufhängungssystem durch Bonding auf der Trägerstruktur befestigt wird. Fig. 9B veranschaulicht den ersten Fertigungsschritt. Ein Haltesubstrat HS in Form eines ebenen Wafers wird an einer Seite mit einer Trennschicht SEP versehen. Auf dieser wird eine Gruppe erster Spiegelelemente MU1 mit gleicher Orientierung der Trapezform angebracht. Im Beispielsfall sind die Spiegelelemente jeweils so orientiert, dass die mit Spiegelbeschichtung zu versehende Vorderseite kleiner ist als die Rückseite des Spiegelsubstrats, an der der Fuß (post) STD angebracht ist. Zwischen den einzelnen Spiegeleinheiten bleiben in der gezeigten Schnittrichtung und schräg dazu Lücken für die umgekehrt orientierten zweiten Spiegelsubstrate SUB2. Die vom Haltesubstrat noch gehaltenen Spiegelelemente werden dann in einem Bonding-Schritt (z.B. eutektisches Bonding oder Thermobonding) mit der Oberseite der Trägerstruktur TS unter Einwirkung von Druck und Temperatur fest verbunden, so dass die zentrischen Ständer STD an der Trägerstruktur befestigt sind. Dann wird die Trennschicht so weit aufgeheizt oder aufgelöst, dass das Haltesubstrat entfernt werden kann. Alternativ kann die Halteschicht mit dem Haltesubstrat chemisch oder durch Plasmaätzen weggeätzt werden.

Danach wird in einem zweiten Schritt (Fig. 9C) die zweite Gruppe von zweiten Spiegeleinheiten MU2 in analoger Weise mit der Trägerstruktur verbunden. Die zweite Gruppe umfasst jeweils diejenigen zweiten Spiegelsubstrate, deren breitere Seiten nun an dem Haltesubstrat HS angebracht sind und die schmalere Seite mit Aufhängung der Trägerstruktur TS zugewandt ist. Der zweite Bonding-Schritt ist möglich, da sich die Lücken zwischen den im ersten Schritt aufgebrachten ersten Spiegeleinheiten MU1 der ersten Gruppe nach oben erweitern, so dass die dazwischen anzuordnenden umgekehrt orientierten zweiten Spiegeleinheiten alle in einem Schritt eingefügt werden können.

Anhand der Fig. 10A bis 10C wird eine zweite Variante erläutert, die nach Art einer additiven Fertigung abläuft. Dabei entstehen an den Seitenflächen gestufte Spiegelsubstrate dadurch, dass aufeinander liegende Schichten unterschiedlicher lateraler Ausdehnung sukzessive erzeugt werden, um jeweils ein Spiegelsubstrat zu bilden. Fig. 10A zeigt wieder einen Schnitt durch die fertige Mehrfachspiegelanordnung MMA mit schräg orientierten Spalten zwischen den einzelnen Spiegelelementen. Auch hier sind die im Schnitt im Wesentlichen trapezförmigen Spiegelelemente mit alternierender Orientierung zwischen Breitseite und Schmalseite so angeordnet, dass zwischen unmittelbar benachbarten Spiegelelementen jeweils ein schräg gestellter Spalt mit gestuften Seitenbegrenzungen entsteht.

Die Spiegelelemente mitsamt der daran angebrachten Aufhängung werden in einem ersten Schritt (Fig. 10B) an einem Haltesubstrat HS erzeugt. Dieses wird zunächst mit einer Trennschicht SEP beschichtet. Danach wird eine erste Schicht aufgebracht, die zunächst durchgängig aus dem für die Spiegelsubstrate vorgesehenen Material, beispielsweise Silizium, besteht. Diese erste Schicht wird dann an denjenigen Stellen, an denen die Spalte zwischen benachbarten Spiegeleinheiten entstehen sollen, in einem lithografischen Prozess strukturiert, wobei Material durch Ätzen entfernt wird. Die entstehenden Lücken in der ersten Schicht werden dann durch Opfermaterial (z.B. SiO₂) gefüllt. Danach folgt ein Planarisierungsschritt, um für die Aufbringung der nächsten Schicht eine ebene Oberfläche zu schaffen, die teils durch das Material der ersten Schicht und im Bereich der Spalte durch das Opfermaterial gebildet wird.

Danach wird eine durchgängige zweite Schicht aus dem für die Bildung der Spiegelsubstrate gewählten Material (beispielsweise Silizium) aufgebracht. Auch diese wird dann im Bereich der Spalte in einem Lithografieprozess strukturiert, indem dort Material der zweiten Schicht durch Ätzen entfernt wird. Abhängig davon, ob ein nach links oder ein rechts verlaufender schräger Spalt zu erzeugen ist, liegen diejenigen Bereiche der zweiten Schicht, die durch Ätzen entfernt werden sollen, entweder lateral links oder lateral rechts von den entsprechenden Bereichen der ersten Schicht. Nach dem Ätzschritt werden die dann leeren Bereiche mit Opfermaterial gefüllt und es folgt ein weiterer Planarisierungsschritt. Nach einer entsprechenden Anzahl von Wiederholungen dieses Strukturierungsprozesses liegen die Spiegelsubstrate in der alternierenden Anordnung der noch mit Opfermaterial gefüllten Spalte vor. Nach Anbringung oder Erzeugung der Aufhängungsstruktur folgt ein Bonding-Schritt (Fig. 10B), mit welchem die einzelnen Spiegelelemente unter Einwirkung von Kraft und Temperatur mit der Trägerstruktur TS verbunden (gebondet) werden. Nach dem Bonding-Schritt werden die mit Opfermaterial gefüllten Volumenbereiche geätzt, um das Opfermaterial zu entfernen. Danach wird noch das Material der Trennschicht SEP entfernt, so dass die Vorderflächen der Spiegelsubstrate freiliegen. Diese werden dann mit einer Reflexbeschichtung beschichtet. Fig. 10C zeigt einen Schnitt durch die fertige Mehrfachspiegelanordnung.

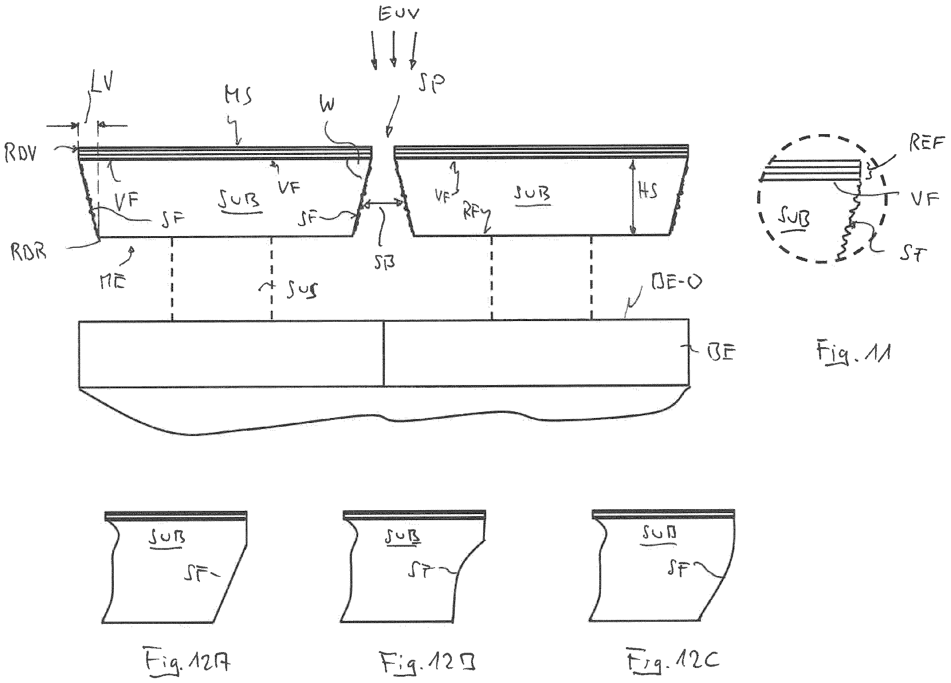

Anhand der nachfolgenden Fig. 11 ff. werden beispielhaft weitere Ansätze zur Lösung der oben beschriebenen Problematik erläutert. Aus Gründen der Übersichtlichkeit werden für strukturell und/oder funktionell gleiche oder ähnliche Merkmale die gleichen Bezugszeichen wie in den obigen Beispielen verwendet. Die Lösungsansätze berücksichtigen unter anderem die folgenden Erkenntnisse.

Die Lage und räumliche Ausdehnung derjenigen Bereiche hinter den Spiegelflächen, in die Strahlung, z.B. die EUV-Strahlung, direkt oder nach Reflexion indirekt gelangen kann, hängen u.a. von der Größe der Spiegelelemente, deren Dicke, deren Höhe oberhalb der durch die Oberflächen BE-O der Basiselemente gebildeten Basisebene, der Höhe der Spiegelfläche über der Lage der individuellen Kippachsen, den maximal erreichbaren Kippwinkeln sowie von den Dimensionen und Positionen der Spalte SP und von der Winkelverteilung der einfallenden Strahlung ab. Diejenigen Flächenbereiche und/oder Volumenbereiche, die der in den Zwischenbereich eindringenden Strahlung ausgesetzt sind, können sich vergrößern, wenn die Spiegelelemente gegeneinander verkippt werden.

Bei den Beschichtungsprozessen zur Erzeugung der reflektierenden Beschichtung REF auf der Vorderfläche VF der Spiegelsubstrate SUB kann es vorkommen, dass Beschichtungsmaterial auch in die Spalte eindringt und dadurch die Seitenflächen SF eine mehr oder weniger stark EUV-Strahlung reflektierende Beschichtung erhalten können.

Die an den Seitenflächen SF reflektierten EUV-Strahlen können ihre Ausbreitungsrichtung relativ zur Einfallsrichtung stark ändern, wobei das Ausmaß der Ablenkungswinkel u.a. von den Einfallswinkeln und den Kippwinkeln der Spiegelelemente abhängt. Dadurch kann EUV-Strahlung auch auf solche Bereiche der Oberfläche BE-O der Basiselemente treffen, die in Abwesenheit von Seitenflächenreflexion im Schatten der Spiegelelemente liegen.

Somit kann es sein, dass diejenigen "bestrahlungsgeschützten" Flächenanteile und Volumenanteile, die nicht der direkten Strahlung ausgesetzt sind, effektiv kleiner sind als bei einer idealen Konfiguration ohne Seitenflächenreflexion. Dadurch können die eingangs erwähnten Probleme, wie strahlungsinduzierte Aufheizung, Degradation unter dem Einfluss von Strahlung durch Ätzen, elektrische Funktionsstörungen an funktionellen elektrischen Teilen etc., und damit einhergehend verkürzte Nutzungsdauern verstärkt werden.

Bei dem Ausführungsbeispiel der EUV-Mehrfachspiegelanordnung MMA in Fig. 11 entsprechen die Spiegeleinheiten MU in deren Grundkomponenten (Basiselement BE, Spiegelelement ME, flexibles Aufhängungssystem SUS, Reflexionsbeschichtung REF) weitgehend dem im Zusammenhang mit Fig. 2 beschriebenen Stand der Technik, weshalb insoweit auf die dortige Beschreibung verwiesen wird.

Wesentliche Unterschiede dazu gibt es im Randbereich der Spiegelelemente im Bereich der Seitenflächen SF der Spiegelsubstrate SUB. Die Seitenflächen sind an den Rändern der Spiegelfläche, also am Übergang zwischen VF Vorderfläche und Seitenfläche SF, nicht im Wesentlichen senkrecht zur spiegelnden Vorderfläche ausgerichtet, sondern jeweils systematisch in einem von 90° abweichenden Winkel W schräg zur zugeordneten Spiegelfläche orientiert. Dabei ist es so, dass die mit Reflexionsbeschichtung REF versehene Vorderfläche VF einen größeren Flächeninhalt aufweist als die gegenüberliegende Seite des Spiegelsubstrats, nämlich die dem Basiselement BE zugewandte Rückfläche RF. Dadurch wird bei dem insgesamt etwa plattenförmigen Spiegelsubstrat erreicht, dass der laterale beziehungsweise äußere Rand RDR der Rückfläche gegenüber dem äußeren Rand RDV der Vorderfläche VF an allen Umfangspositionen um einen lateralen Versatz LV nach innen zurückgesetzt ist. Dadurch erhält das Spiegelsubstrat in der gezeigten Querschnittsebene eine trapezförmige Gestalt mit der breiteren Basis zur reflektierenden Vorderfläche. Auch die in allen Nachbarrichtungen angrenzenden Spiegelsubstrate haben die gleiche Gestalt, so dass sich zwischen benachbarten Spiegelsubstraten jeweils ein Spalt SP ergibt, dessen Spaltbreite SB von der auf Ebene der Vorderflächen liegenden Strahlungseintrittsseite zu der dem Basiselement zugewandten Strahlungsaustrittsseite zunimmt.

Im Beispielsfall der Fig. 11 sind die Seitenflächen jeweils makroskopisch eben, so dass sie mit einheitlichem Winkel W gegenüber der Vorderfläche angestellt sind. Es gibt auch Ausführungsbeispiele, bei denen die Schrägstellung nur abschnittsweise vorliegt, so dass es auch Abschnitte gibt, die mehr oder weniger senkrecht zur Vorderfläche orientiert sind (vgl. Fig. 12A). Seitenflächen können auch wenigstens abschnittsweise konvex (vgl. Fig. 12C) oder konkav (vgl. Fig. 12B) gekrümmt sein.

Der Schrägstellungswinkel W kann der Anwendung angepasst sein. In der Regel sind die Abweichungen von 90° relativ klein, beispielsweise zwischen 2° und 10°, insbesondere zwischen 3° und 8°. Je nach Dicke beziehungsweise Höhe HS des Spiegelsubstrats können sich dadurch laterale Versätze LV in der Größenordnung von einigen Mikrometern ergeben, beispielsweise zwischen 2 µm bis 10 µm. Der laterale Versatz kann beispielsweise zwischen 3% und 10% Dicke HS des Substrats betragen. Abweichungen von diesen beispielhaften Dimensionen sind möglich. Die vorteilhaften technischen Effekte dieser Ausgestaltung werden später im Einzelnen erläutert.

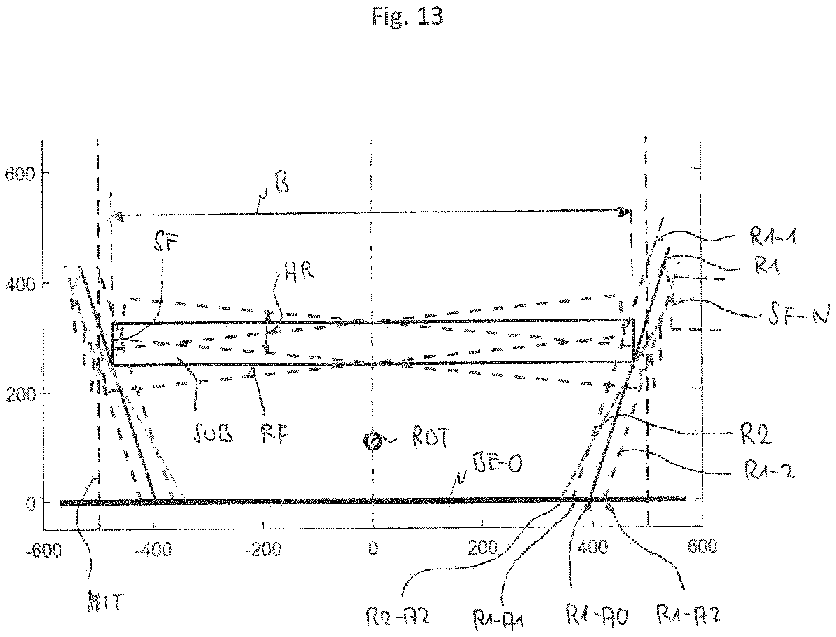

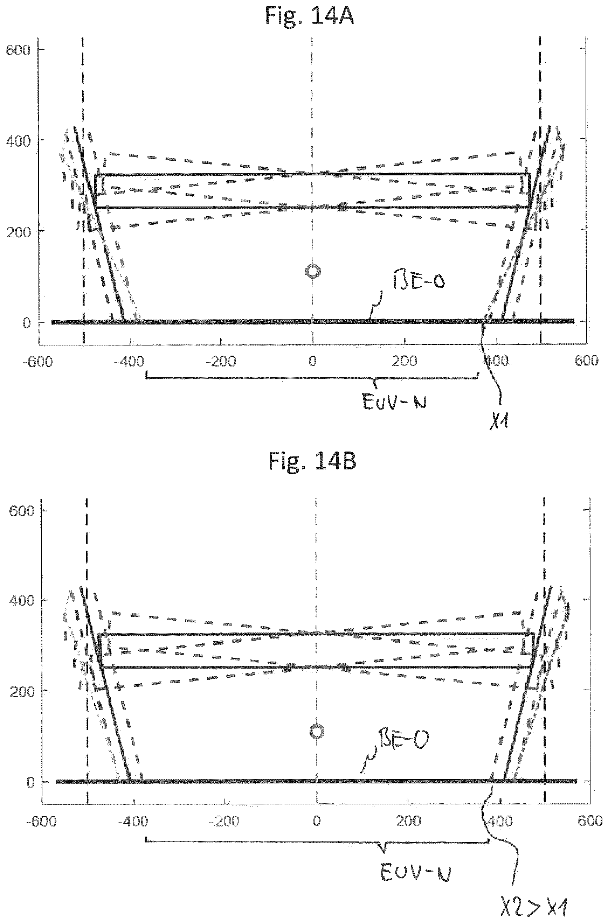

Nachfolgend soll anhand der Fig. 13 und 14 die technische Wirkung der beschriebenen Schrägstellung der Seitenflächen erläutert werden. Zur Abschätzung der Effekte wurden vom Erfinder an einem beispielhaften Modellsystem Strahldurchrechnungen (ray tracing) durchgeführt, um zu ermitteln, in welche Bereiche hinter dem Spiegelsubstrat SUB die EUV-Strahlung oder DUV-Strahlung direkt oder über Reflexion an Seitenflächen bei einer vorgegebenen Einfallswinkelverteilung gelangen kann. Dabei wurde jeweils ein Referenzbeispiel eines plattenförmigen Spiegelsubstrats mit senkrechten Seitenflächen betrachtet und im Vergleich dazu ein Ausführungsbeispiel mit schräg gestellten Seitenflächen. Ohne Beschränkung der Allgemeinheit wurde für die Breite B zwischen gegenüberliegenden Seitenflächen an der Vorderfläche ein Wert von BV=950 µm und an der Rückfläche ein Wert BR = 940 µm bei einer Dicke HR von 75 µm angenommen. Der laterale Versatz LV betrug somit an jeder Seite 5 µm.

Für die Höhe der Rückseite des Spiegelsubstrats gegenüber der Basisebene (Oberfläche BE-O der Basiselemente) wurde als typische Größe ein Wert von 250 µm angenommen.

Das Diagramm in Fig. 13 veranschaulicht das Modellsystem, in welchem das Substrat SUB in seiner unverkippten Neutralstellung als flaches Rechteck mit durchgezogener Linie gezeigt ist. Mit gestrichelten Linien sind die Extremwerte der Verkippungen nach links und rechts dargestellt. Maximale angenommene Kippwinkel lagen in der Größenordnung von 100 mrad zu jeder Seite. In der Regel können die Kippwinkel pro Seite z.B. im Bereich von 50 mrad bis 150 mrad liegen. Die Verkippungen erfolgen um die Kippachse oder Drehachse ROT, die zwischen Spiegelelement und Basisebene (Breitenkoordinate 0 auf der y-Achse des Diagramms) auf einer Höhe von ca. 125 µm liegt. Die senkrechten gestrichelten Linien bei x = -500 und x = 500 µm entsprechen den Mittelebenen MIT der Spalte zwischen benachbarten Spiegeleinheiten und somit den Rändern des Bereichs einer einzelnen Spiegeleinheit.

Für die einfallende (EUV-)Strahlung wird ein Einfallswinkelspektrum angenommen, dessen Einfallswinkel zwischen normaler Inzidenz (Einfallswinkel von 0° in Bezug auf die Oberflächennormale eines unverkippten Spiegelsubstrats) und einem maximalen Einfallswinkel in der Größenordnung von ca. 10 bis 20 ° liegen.

Im Randbereich der Spiegelsubstrate sind unterschiedliche repräsentative Strahlen eingezeichnet.

Die durchgezogene Linie R1 repräsentiert den ungünstigsten Strahl eines Einfallsrichtungsspektrums im Falle eines unverkippten Spiegelsubstrats. Dieser Strahl R1 tangiert gerade die zwischen Seitenfläche und Rückfläche gebildete untere Kante des Spiegelsubstrats und trifft am Ort R1-A0 auf die Basisebene BE-O. Wird das Spiegelelement nach links verkippt, so rückt die rechte Hinterkante des Spiegelsubstrats nach innen in Richtung niedrigerer Absolutwerte der Ortskoordinate x. Dadurch gibt es einen Strahl R1-1, der denselben Einfallswinkel hat wie der Strahl R1, nun aber die Hinterkante des gekippten Spiegelsubstrats tangiert und am Ort R1-A1 auf die Basisebene trifft. Aufgrund der Verkippung des Spiegels nach links liegt dieser näher am Mittelpunkt des Spiegelelementes (bei x=0). Dies veranschaulicht, dass durch Verkippung des Spiegels die in der Basisebene BE-O um die Mitte der Spiegeleinheit herum liegenden unbestrahlten Flächen beziehungsweise Volumina kleiner werden können.

Wird das Spiegelsubstrat nach rechts gekippt, ergibt sich für die Strahlen R1-2 mit dem ungünstigsten Einfallswinkel ein Auftreffort R1-A2, der weiter von der Mitte entfernt liegt als bei unverkipptem Substrat. Dies veranschaulicht, dass die Größe der unbestrahlten Bereiche hinter den Spiegelsubstraten unter anderem vom Kippwinkel und dem Einfallswinkelspektrum abhängt.

Die Simulation bzw. Strahldurchrechnung berücksichtigt auch Reflexionen von Strahlen an Seitenflächen SF. Hierzu wird im Beispielsfall die Reflexion an der Seitenfläche SF-N des unmittelbar benachbarten Spiegelsubstrats betrachtet, welches im Beispielsfall nach rechts gekippt ist. Der Strahl R2 repräsentiert den ungünstigsten reflektierten Strahl, der unter relativ großem Einfallswinkel (mit mehr oder weniger streifendem Einfall) auf die als reflektierend angenommene Seitenfläche SF-N trifft und von dort in Richtung Basisebene reflektiert wird. Der Auftreffpunkt R2-A2 dieses einfach reflektierten Strahls liegt noch weiter innerhalb des Spiegelsubstrats, also näher bei dessen Mitte und verkleinert dadurch die Größe desjenigen Bereichs um die Mitte, der von EUV-Strahlung nicht direkt getroffen wird. Die Größe dieses Bereichs nimmt mit zunehmenden Kippwinkeln und zunehmender Höhe des Spiegelelements über der Basisebene ab. Entsprechende Verhältnisse ergeben sich an der gegenüberliegenden Seite und auch an den anderen Seitenflächen eines Spiegelsubstrats.

Basierend auf diesem geometrischen Modell wurde untersucht, welchen Einfluss die Schrägstellung von Seitenflächen auf die Größe des nicht direkt bestrahlten Bereichs unterhalb des Spiegelsubstrats für einen gegebenen Einfallswinkelbereich hat. Die Fig. 14A und Fig. 14B veranschaulichen einen Vergleich. Fig. 14A repräsentiert dabei ein herkömmliches Substrat mit senkrecht zur Vorderfläche gerichteten Seitenflächen, während Fig. 14B die Berechnungen an einem Substrat veranschaulicht, dessen Seitenflächen um einige Grad (ca. 5°) schräg gestellt und dadurch nach innen zurückversetzt sind.

Für die gegebene Einfallswinkelverteilung ergibt sich im Falle eines konventionellen Substrats mit senkrechten Seitenflächen (Fig. 14A), dass der äußere Rand des mittig hinter dem Spiegelsubstrat liegenden Bereichs EUV-N, der keine direkte EUV-Bestrahlung erleidet, bei ca. 341 µm liegt (entsprechend x-Koordinate X1). Sind dagegen die Seitenflächen nach innen schräg zurückgestellt (Fig. 14B), so verlagert sich dieser äußere Rand des der EUV-Strahlung nicht direkt ausgesetzten inneren Bereichs EUV-N nach außen auf ca. 359 µm (entsprechend x-Koordinate X2 > X1). Der nicht bestrahlbare Bereich EUV-N wird somit signifikant größer als im Falle senkrechter Seitenwände.

Dieses Resultat ist repräsentativ für viele Beispiele bei geeigneter Wahl der Schrägstellung der Seitenflächen und typischer Einfallswinkelverteilung. Aufgrund der nach innen schräg gestellten Seitenflächen vergrößert sich somit die "sichere" dunkle Fläche auf dem Basiselement der Spiegeleinheit und die direkter EUV- oder DUV-Strahlung ausgesetzten Bereiche unterhalb der Spalte SP werden kleiner.

Nachfolgend sei auf einen weiteren Unterschied zum Stand der Technik verwiesen. Die Vorderfläche VF, auf die die Reflexionsbeschichtung REF aufgebracht wird, muss mit hoher optischer Qualität zum Beispiel durch Polieren vorbereitet werden, um möglichst geringe Oberflächenrauheit zu erhalten. Die Oberflächenrauheit liegt typischerweise im Bereich unterhalb von 1 nm RMS (quadratische Rauheit), insbesondere kann die Oberflächenrauheit im Bereich von unterhalb 0,2 nm RMS liegen.

Die Seitenflächen SF werden herkömmlich zwar nicht mit derart hoher Präzision geätzt, die Oberflächenrauheit kann aber durchaus relativ gering sein, beispielsweise im Bereich von wenigen oder wenigen zehn nm RMS.

Im Gegensatz dazu sind die Seitenflächen SF beim Ausführungsbeispiel durch geeignete Oberflächenbearbeitung stark aufgeraut, so dass die Seitenflächen eine Oberflächenrauheit erhalten, die wenigstens eine Größenordnung, vorzugsweise auch zwei oder mehr Größenordnungen, größer ist als die diejenige der Vorderfläche VF. Die Oberflächenrauheit kann beispielsweise bei mindestens 100 nm RMS oder gar im Bereich von oberhalb 1 µm RMS liegen. An derartig rauen Oberflächen kann keine spekulare Reflexion stattfinden, selbst wenn sie eine prinzipiell reflektierend wirkende Beschichtung tragen. Sie wirken auf eventuell auftreffende EUV-Strahlung überwiegend streuend.

Besonders günstig im Hinblick auf die Vermeidung direkter Einstrahlung von EUV-Strahlung hinter die Ebene der Spiegelflächen sind Kombinationen der in Fig. 11 gezeigten Art, wo die geometrische Maßnahme der Schrägstellung der Seitenflächen SF mit der Aufrauhung der Seitenflächen kombiniert wird. Dadurch wird der Anteil an EUV-Strahlung, der durch Interaktion mit den Seitenflächen SF in den Bereich hinter die Spiegelsubstrate gelenkt wird, nochmals reduziert. Dabei kann ein Teil der Strahlungsenergie in den Seitenflächen absorbiert werden, ein anderer Teil kann dann durch Streuung über einen größeren Raumwinkelbereich verteilt werden, so dass die lokal wirksame Intensität gering bleibt. Somit können die Risiken aufgrund EUVstrahlungsinduzierter Probleme aller Art reduziert werden.

Für die Herstellung der Spiegelsubstrate mit schräg nach innen versetzten Seitenflächen können an sich bekannte Techniken aus dem Bereich der Herstellung von mikro-elektronischmechanischen Systemen (MEMS) genutzt werden. Insbesondere können Varianten des Deep Reactive Ion Etchings (DRIE, Reaktives lonentiefenätzen, auch als Bosch-Prozess bekannt), genutzt werden, um in Volumenbereichen eines Substratmaterials, insbesondere Silizium), die als Spiegelsubstrate dienen sollen, entsprechend tiefe Gräben mit schrägen Seitenwänden zu erzeugen. Zum Verfahren DRIE sei beispielhaft auf folgende Veröffentlichung verwiesen: R Li, Y Lamy, W F A Besling, F Roozeboom, P M Sarro, "Continuous deep reactive ion etching of tapered via holes for three-dimensional integration", J. Micromech. Microeng. 18 (2008) 125023 doi:10.1088/0960-1317/18/12/125023

Geeignete DRIE-Verfahren umfassen Zyklen mit Passivierung und Ätzen. Zur Passivierung kann ein Loch durch Abscheiden von Teflon-artigen Passivierungsschichten geschützt werden. In den Ätzschritten, die hochgradig anisotrop sein können, werden Ionen im Wesentlichen vertikal beschleunigt, um das Passivierungsmaterial vom Boden eines Grabens zu beseitigen, wobei gleichzeitig die Passivierung an den Seitenwänden erhalten bleibt. Dann können einige Mikrometer Substratmaterial (z.B. Silizium) geätzt werden, bevor der nächste Passivierungsschritt stattfindet. Das Tiefenprofil der geätzten Gräben kann durch verschiedene Prozessparameter wie Gasfluss, Ionenleistung, Drücke und die Verhältnisse zwischen Zeiten mit Passivierung und Ätzen eingestellt werden. Somit können unter anderem auch Gräben erzeugt werden, die im Eingangsbereich enger oder breiter sind als in der Tiefe. Da solche Prozesse an sich bekannt sind, wird auf eine eingehende Beschreibung des Herstellungsprozesses verzichtet.

## Patentansprüche

1. Mehrfachspiegelanordnung (20, 22, MMA) umfassend:
eine Trägerstruktur (TS),
eine Vielzahl von Spiegeleinheiten (MU), die an der Trägerstruktur in einer Rasteranordnung nebeneinander angeordnet sind, wobei:
jede Spiegeleinheit (MU) ein Basiselement (BE) und ein gegenüber dem Basiselement (BE) individuell beweglich gelagertes Spiegelelement (ME) aufweist, welches ein Spiegelsubstrat (SUB) aufweist, das an einer dem Basiselement (BE) abgewandten Vorderfläche eine Reflexionsbeschichtung (REF) zur Bildung einer Ultraviolettstrahlung reflektierenden Spiegelfläche (MS) trägt, eine dem Basiselement zugewandte Rückfläche und an seinem Umfang Seitenflächen aufweist;
die Anordnung der Spiegelelemente konstruktiv so ausgelegt ist, dass eine Relativbewegung der Spiegelelemente zueinander in einem vorgesehenen Bewegungsbereich der Spiegelelemente ohne gegenseitige Kollision erfolgt,
die Spiegelflächen (MS) im wesentlichen flächenfüllend nebeneinander angeordnet sind und zwischen unmittelbar benachbarten Spiegelelementen ein durch Seitenflächen (SF1, SF2) der angrenzenden Spiegelsubstrate (SUB) begrenzter Spalt (SP) zur Sicherstellung einer kollisionsfreien Relativbewegung der benachbarten Spiegelelemente verbleibt, und
bei jeder Spiegeleinheit (MU) in einem Zwischenraum (ZR) zwischen dem Basiselement (BE) und dem Spiegelelement (ME) funktionelle Komponenten der Spiegeleinheit angeordnet sind;
**dadurch gekennzeichnet, dass** die Seitenflächen (SF1, SF2) der Spiegelsubstrate (SUB1, SUB2) jeweils wenigstens abschnittsweise in einem von 90° abweichenden Winkel schräg zur zugeordneten Spiegelfläche (MS) orientiert sind.

2. Mehrfachspiegelanordnung nach Anspruch 1, **dadurch gekennzeichnet, dass** in dem Zwischenraum (ZR) zwischen dem Basiselement (BE) und dem Spiegelelement (ME) funktionelle Komponenten der Spiegeleinheit in Form von Komponenten eines Aufhängungssystems (SUS) zur beweglichen Lagerung des Spiegelelements (ME) an dem Basiselement (BE) sowie Komponenten eines Aktuatorsystems (AKT) zur Erzeugung von Bewegungen des Spiegelelements (ME) relativ zum Basiselement (BE) in Reaktion auf den Empfang von Steuersignalen angeordnet sind, wobei vorzugsweise wenigstens das Basiselement (BE), das Aufhängungssystem (SUS) und das Aktuatorsystem (AKT) als MEMS-Struktur aus Silizium, Si, oder einer Silizium-Verbindung ausgebildet sind, und/oder **dadurch gekennzeichnet, dass** die Reflexionsbeschichtung (REF) eine für EUV-Strahlung und/oder DUV-Strahlung reflektierende Spiegelfläche (MS) bildet.

3. Mehrfachspiegelanordnung nach Anspruch 1 oder 2, **dadurch gekennzeichnet, dass** die Seitenflächen von Spiegelsubstraten (SUB) unmittelbar benachbarter Spiegelsubstrate (SUB1, SUB2) jeweils derart ausgebildet und orientiert sind, dass der zwischen unmittelbar benachbarten Spiegelsubstraten gebildete Spalt (SP) eine Spaltbreite (SB) aufweist, die von der mit der Reflexionsbeschichtung (REF) versehene Vorderfläche (VF) eines Spiegelelements in Richtung des Basiselements (BE) zunimmt und/oder dass die mit der Reflexionsbeschichtung (REF) versehene Vorderfläche (VF) eines Spiegelelements einen größeren Flächeninhalt aufweist als eine vom äußeren Rand der, vorzugsweise parallel zur Vorderfläche verlaufenden, Rückfläche umschlossene Fläche, wobei der äußere Rand der Rückfläche gegenüber einem äußeren Rand der Vorderfläche an allen Umfangspositionen um einen lateralen Versatz (LV) nach innen zurückgesetzt ist, wobei vorzugsweise das Spiegelsubstrat eine zwischen der Vorderfläche und der Rückfläche gemessene Dicke aufweist und der Versatz (LV) mindestens 3%, vorzugsweise mindestens 5% der Dicke und/oder höchstens 10 % der Dicke beträgt.

4. Mehrfachspiegelanordnung nach einem der vorhergehenden Ansprüche, **dadurch gekennzeichnet, dass** ein am Übergang zwischen der Vorderfläche (VF) und der angrenzenden Seitenfläche (SF) eingeschlossene Winkel (W) im Bereich von 80° bis 89° liegt, insbesondere im Bereich von 84 ° bis 88°.

5. Mehrfachspiegelanordnung nach einem der vorhergehenden Ansprüche, **dadurch gekennzeichnet, dass** die Spiegelsubstrate (SUB1, SUB2) in einem zwischen gegenüberliegenden Seitenflächen geführten Schnitt eine im Wesentlichen trapezförmige Querschnittsgestalt mit einer breiteren Basis an der Seite der Vorderfläche (VF) aufweisen.

6. Mehrfachspiegelanordnung nach einem der vorhergehenden Ansprüche, **dadurch gekennzeichnet, dass** die Seitenflächen (SF) eine Oberflächenrauheit aufweisen, die mindestens eine Größenordnung größer ist als die Oberflächenrauheit der mit der Reflexionsbeschichtung (REF) versehenen Vorderfläche (VF), wobei die Oberflächenrauheit der Seitenflächen vorzugsweise mindestens 100 nm RMS beträgt.

7. Mehrfachspiegelanordnung nach Anspruch 1 oder 2, **dadurch gekennzeichnet, dass** die Randbereiche von Spiegelsubstraten (SUB) unmittelbar benachbarter Spiegelsubstrate (SUB1, SUB2) jeweils in einem von 90° abweichenden Winkel schräg zur zugeordneten Spiegelfläche (MS) derart orientiert sind, dass die schrägen Seitenflächen einen schräg zu den Spiegelflächen (MS) orientierten Spalt (SP) begrenzen, wobei vorzugsweise der Spalt (SP) angrenzend an die Spiegelflächen (MS1, MS2) eine erste Spaltöffnung (SO1) mit einer ersten Spaltbreite und angrenzend an Rückseiten der Spiegelsubstrate eine zweite Spaltöffnung (SO2) mit einer zweiten Spaltbreite aufweist, wobei die erste und die zweite Spaltöffnung aufgrund der schrägen Orientierung des Spalts (SP) einen lateralen Versatz (LV) aufweisen, so dass eine für einen direkten Strahlungsdurchtritt effektive Spaltbreite kleiner ist als die erste Spaltbreite (SB1) und/oder die zweite Spaltbreite (SB2), wobei vorzugsweise der laterale Versatz (LV) mindestens so groß ist wie das Maximum aus der ersten Spaltbreite (SB1) und der zweite Spaltbreite (SB2).

8. Mehrfachspiegelanordnung nach einem der vorhergehenden Ansprüche, **dadurch gekennzeichnet, dass** die Spiegelsubstrate in einem zwischen gegenüberliegenden Seitenflächen geführten Schnitt eine im Wesentlichen trapezförmige Querschnittsgestalt aufweisen, wobei vorzugsweise in einer Reihe aufeinanderfolgende Spiegelelemente abwechselnd umgekehrte trapezförmige Querschnittsgestalt aufweisen, so dass sich die Orientierung der dazwischenliegenden schrägen Spalte von Spalt zu Spalt alternierend ändert.

9. Mehrfachspiegelanordnung nach einem der Ansprüche 2 bis 8, **gekennzeichnet durch** eine steuerbare Höhenverstelleinrichtung (HVE) zur reversiblen, stufenlosen Höhenverstellung einzelner Spiegelelemente (ME) gegenüber benachbarten Spiegelelementen (ME) in Reaktion auf Steuersignale, wobei vorzugsweise die Basiselemente (BE) gegenüber der Trägerstruktur individuell höhenverstellbar sind, insbesondere mittels eine dickenveränderlichen piezoelektrischen Schicht zwischen Trägerelement und Basiselement, und/oder das Aktuatorsystem zur Erzeugung einer Bewegung eines Spiegelelements (ME) in zwei rotatorischen und einem translatorischen Freiheitsgrad ausgelegt ist, wobei der translatorische Freiheitsgrad einer Bewegung des Spiegelelements (ME) entlang einer Translationsachse entspricht, die senkrecht oder schräg auf Rotationsachsen der rotatorischen Freiheitsgrade steht, wobei vorzugsweise eine Steuerung der Höhenverstelleinrichtung (HVE) derart konfiguriert ist, dass eine Höhenverstellung eines Spiegelelements in Abhängigkeit von Kippstellungen benachbarter Spiegelelemente erzeugbar ist.

10. Mehrfachspiegelanordnung nach einem der vorhergehenden Ansprüche, **gekennzeichnet durch** Strahlungsfallenelemente (TRP), die eine Strahlungsauftrefffläche (AF) aufweisen, welche an der den Spiegelflächen abgewandten Rückseite der Spiegelsubstrate (SUB) im Bereich der Spalte (SP) angeordnet ist, wobei vorzugsweise die Strahlungsfallenelemente (TRP) wenigstens im Bereich der Strahlungsauftrefffläche (AF) aus einem Funktionsmaterial (FM) bestehen, welches wenigstens eine der folgenden Eigenschaften aufweist:
das Funktionsmaterial (FM) ist ein für EUV-Strahlung absorbierend wirkendes Absorbermaterial; das Funktionsmaterial (FM) ist ein Rekombinationskatalysator, welcher bei Kontakt mit Wasserstoffionen eine Rekombinationswahrscheinlichkeit für Wasserstoffionen erhöht.
das Funktionsmaterial (FM) ist ausgewählt aus der Gruppe: Ruthenium, Ru, Platin, Pt, Rhenium, Re, Rhodium, Rh, Iridium, Ir, Molybdän, Mo, Nickel, Ni, und Eisen, Fe,
wobei vorzugsweise die Strahlungsfallenelemente (TRP) abschnittsweise in der Höhe verstellbar sind, wobei vorzugsweise eine Höheneinstellung des jeweiligen Strahlungsfallenelements (TRP) in Abhängigkeit von Kippstellungen und/oder Höhenstellungen benachbarter Spiegelelemente (ME) erzeugbar ist.

11. Mehrfachspiegelanordnung nach einem der vorhergehenden Ansprüche, **dadurch gekennzeichnet, dass** wenigstens eine Schutzmembran (MEM) vorgesehen ist, die einen Spaltabdeckabschnitt (AA) aufweist, der einen zwischen unmittelbar benachbarten Spiegelsubstraten (SUB1, SUB2) gebildeten Spalt (SP) überbrückt und die den Spalt begrenzenden Spiegelsubstrate kontaktiert, insbesondere an den Spiegelsubstraten (SUB1, SUB2) befestigt ist, wobei vorzugsweise die Schutzmembran (MEM3) im Bereich des Spaltabdeckabschnitts (AA) ein für EUV-Strahlung absorbierend wirkendes Absorbermaterial aufweist, wobei das Absorbermaterial vorzugsweise aus der Gruppe: Ruthenium, Ru, Platin, Pt, Rhenium, Re, Rhodium, Rh, Iridium, Ir, Molybdän, Mo, Nickel, Ni, und Eisen, Fe, ausgewählt ist.

12. Mehrfachspiegelanordnung nach Anspruch 11, **dadurch gekennzeichnet, dass** die Schutzmembran (MEM) an der Vorderseite der Spiegelsubstrate (SUB1, SUB2) in einer Mehrlagen-Schichtanordnung zwischen den Spiegelsubstraten (SUB1, SUB2) und der Reflexionsbeschichtung (REF) angeordnet ist und/oder dass wenigstens eines der folgenden Merkmale gegeben ist:
eine Schutzmembran (MEM4) ist an der Rückseite der Spiegelsubstrate (SUB1, SUB2) angeordnet;
eine Schutzmembran (MEM5) ist zwischen der Rückseite des Spiegelsubstrats (SUB) und einer Rückseite des Strahlungsfallenelements (TRP) angeordnet;
eine kippstellungsabhängige Höhenverstellung des Strahlungsfallenelements (TRP) durch die Schichtspannung der Schutzmembran (MEM5) zwischen der Spiegeleinheit (MU) und dem Strahlungsfallenelement (TRP).

13. Mehrfachspiegelanordnung nach einem der vorhergehenden Ansprüche, **gekennzeichnet durch** eine Ätzschutzstruktur in Form einer Ätzschutzschicht (SS), die in einem durch Ätzangriff gefährdeten Bereich auf eine aus einem Komponentenmaterial bestehende Komponente der Spiegeleinheit aufgebracht ist, wobei die Ätzschutzschicht wenigstens ein Schutzschichtmaterial aufweist, das gegenüber einem Ätzangriff mit Wasserstoffionen einen höhere Ätzbeständigkeit besitzt als das Komponentenmaterial.

14. Mehrfachspiegelanordnung nach einem der vorhergehenden Ansprüche, **dadurch gekennzeichnet, dass** die Reflexionsbeschichtung (REF) für EUV-Strahlung einen hohen Reflexionsgrad aufweist, so dass die Mehrfachspiegelanordnung als EUV Mehrfachspiegelanordnung ausgelegt ist.

15. Beleuchtungssystem (2) für eine UV-Anlage (1), wobei das Beleuchtungssystem (2) dazu ausgebildet ist, im Betrieb der UV-Anlage UV-Strahlung einer UV-Strahlungsquelle (3) zu empfangen und aus mindestens einem Anteil der empfangenen UV-Strahlung Beleuchtungsstrahlung zu formen, die in ein Beleuchtungsfeld in einer Austrittsebene (6) des Beleuchtungssystems gerichtet ist, **dadurch gekennzeichnet, dass** das Beleuchtungssystem (4) mindestens eine Mehrfachspiegelanordnung (MMA, 20, 22) gemäß einem der vorhergehenden Ansprüche aufweist.

## Claims

1. Multi-mirror array (20, 22, MMA), comprising:
a carrier structure (TS),
a multiplicity of mirror units (MU) arranged next to one another on the carrier structure in a grid arrangement, with:
each mirror unit (MU) comprising a base element (BE) and, opposite the base element (BE), an individually movably mounted mirror element (ME), which comprises a mirror substrate (SUB) which on a front face facing away from the base element (BE) carries a reflection coating (REF) for forming an ultraviolet radiation-reflecting mirror surface (MS), comprises a back face facing the base element and comprises side faces on its circumference;
the array of mirror elements being structurally designed so that a relative movement of the mirror elements with respect to one another is implemented without mutual collision in an envisaged movement range of the mirror elements,
the mirror surfaces (MS) being arranged next to one another in a manner substantially filling the area and a gap (SP) which is delimited by side faces (SF1, SF2) of the adjacent mirror substrates (SUB) remaining between immediately adjacent mirror elements, for the purpose of ensuring a collision-free relative movement of the adjacent mirror elements, and
functional components of the mirror unit being arranged in an intermediate space (ZR) between the base element (BE) and the mirror element (ME) in the case of each mirror unit (MU);
**characterized in that** at least portions of each of the side faces (SF1, SF2) of the mirror substrates (SUB1, SUB2) are oriented obliquely with respect to the assigned mirror surface (MS) at an angle that deviates from 90°.

2. Multi-mirror array according to Claim 1, **characterized in that** functional components of the mirror unit in the form of components of a suspension system (SUS) for movably mounting the mirror element (ME) on the base element (BE) and components of an actuator system (AKT) for creating movements of the mirror element (ME) relative to the base element (BE) in response to the reception of control signals are arranged in the intermediate space (ZR) between the base element (BE) and the mirror element (ME), with preferably at least the base element (BE), the suspension system (SUS) and the actuator system (AKT) being designed as a MEMS structure made of silicon, Si, or a silicon compound, and/or **characterized in that** the reflection coating (REF) forms an EUV radiation-reflecting and/or DUV radiation-reflecting mirror surface (MS).

3. Multi-mirror array according to Claim 1 or 2, **characterized in that** the side faces of mirror substrates (SUB) of immediately adjacent mirror substrates (SUB1, SUB2) are each designed and oriented such that the gap (SP) formed between immediately adjacent mirror substrates has a gap width (SB) which, from the front face (VF) of a mirror element provided with the reflection coating (REF), increases in the direction of the base element (BE) and/or **in that** the front face (VF) of a mirror element provided with the reflection coating (REF) has a greater surface area than an area enclosed by the outer edge of the back face, which preferably extends parallel to the front face, with the outer edge of the back face being inwardly recessed by a lateral offset (LV) in relation to an outer edge of the front face at all circumferential positions, with preferably the mirror substrate having a thickness measured between the front face and the back face and the offset (LV) being at least 3%, preferably at least 5% of the thickness and/or no more than 10% of the thickness.

4. Multi-mirror array according to any of the preceding claims, **characterized in that** an included angle (W) at the transition between the front face (VF) and the adjacent side face (SF) is in the range from 80° to 89°, in particular in the range from 84° to 88°.

5. Multi-mirror array according to any of the preceding claims, **characterized in that** the mirror substrates (SUB1, SUB2) have a substantially trapezoidal cross-sectional form with a wider base on the side of the front face (VF) in a section guided between opposite side faces.

6. Multi-mirror array according to any of the preceding claims, **characterized in that** the side faces (SF) have a surface roughness which is at least one order of magnitude greater than the surface roughness of the front face (VF) provided with the reflection coating (REF), with the surface roughness of the side faces preferably being at least 100 nm RMS.

7. Multi-mirror array according to Claim 1 or 2, **characterized in that** the edge regions of mirror substrates (SUB) of immediately adjacent mirror substrates (SUB1, SUB2) are each oriented obliquely with respect to the assigned mirror surface (MS) at an angle deviating from 90°, such that the oblique side faces delimit a gap (SP) oriented obliquely with respect to the mirror surfaces (MS), wherein preferably the gap (SP) has a first gap opening (SO1) with a first gap width adjacent to the mirror surfaces (MS1, MS2) and a second gap opening (SO2) with a second gap width adjacent to back sides of the mirror substrates, with the first and the second gap opening having a lateral offset (LV) on account of the oblique orientation of the gap (SP), with the result that an effective gap width for a direct radiation passage is smaller than the first gap width (SB1) and/or the second gap width (SB2), with the lateral offset (LV) preferably being at least as large as the maximum of the first gap width (SB1) and the second gap width (SB2).

8. Multi-mirror array according to any of the preceding claims, **characterized in that** the mirror substrates have a substantially trapezoidal cross-sectional form in a section guided between opposite side faces, with successive mirror elements in a row preferably having reversed trapezoidal cross-sectional form in alternation, with the result that the orientation of the interposed oblique gaps changes from gap to gap in alternation.

9. Multi-mirror array according to any of Claims 2 to 8, **characterized by** a controllable height adjustment device (HVE) for the reversible, continuous height adjustment of individual mirror elements (ME) in relation to adjacent mirror elements (ME) in response to control signals, with the base elements (BE) preferably being height-adjustable on an individual basis in relation to the carrier structure, in particular by means of a thickness-changeable piezoelectric layer between the carrier element and base element, and/or the actuator system being designed to create a movement of a mirror element (ME) in two rotational and one translational degree of freedom, with the translational degree of freedom corresponding to a movement of the mirror element (ME) along a translation axis which is perpendicular or at an angle to axes of rotation of the rotational degrees of freedom, wherein preferably a controller of the height adjustment device (HVE) is configured such that a height adjustment of a mirror element is creatable dependent on tilt positions of adjacent mirror elements.

10. Multi-mirror array according to any of the preceding claims, **characterized by** radiation trap elements (TRP) comprising a radiation incidence surface (AF) arranged on the back side of the mirror substrates (SUB) facing away from the mirror surfaces in the region of the gaps (SP), with preferably at least the region of the radiation incidence surface (AF) of the radiation trap elements (TRP) consisting of a functional material (FM) having at least one of the following properties:
the functional material (FM) is an absorber material with an absorbent effect for EUV radiation; the functional material (FM) is a recombination catalyst which, upon contact with hydrogen ions, increases a recombination probability for hydrogen ions;
the functional material (FM) is selected from the group: ruthenium, Ru, platinum, Pt, rhenium, Re, rhodium, Rh, iridium, Ir, molybdenum, Mo, nickel, Ni, and iron, Fe,
wherein preferably portions of the radiation trap elements (TRP) are height-adjustable, with a height adjustment of the respective radiation trap element (TRP) preferably being creatable dependent on tilt positions and/or height positions of adjacent mirror elements (ME).

11. Multi-mirror array according to any of the preceding claims, **characterized in that** at least one protective membrane (MEM) is provided, the latter comprising a gap covering portion (AA) which bridges a gap (SP) formed between immediately adjacent mirror substrates (SUB1, SUB2) and which is in contact with the mirror substrates delimiting the gap, in particular is fastened to the mirror substrates (SUB1, SUB2), wherein preferably the protective membrane (MEM3) in the region of the gap covering portion (AA) comprises an absorber material with an absorbent effect for EUV radiation, the absorber material preferably being selected from the group: ruthenium, Ru, platinum, Pt, rhenium, Re, rhodium, Rh, iridium, Ir, molybdenum, Mo, nickel, Ni, and iron, Fe.

12. Multi-mirror array according to Claim 11, **characterized in that** the protective membrane (MEM) is arranged on the front side of the mirror substrates (SUB1, SUB2) in a multilayer layer arrangement between the mirror substrates (SUB1, SUB2) and the reflection coating (REF) and/or **in that** at least one of the following features is present:
a protective membrane (MEM4) is arranged on the back side of the mirror substrates (SUB1, SUB2);
a protective membrane (MEM5) is arranged between the back side of the mirror substrate (SUB) and a back side of the radiation trap element (TRP);
a tilt position-dependent height adjustment of the radiation trap element (TRP) by way of the layer stress of the protective membrane (MEM5) between the mirror unit (MU) and the radiation trap element (TRP).

13. Multi-mirror array according to any of the preceding claims, **characterized by** a corrosion protection structure in the form of a corrosion protection layer (SS), which in a region vulnerable to corrosive attack is applied to a component of the mirror unit consisting of a component material, with the corrosion protection layer comprising at least one protection layer material which has a greater corrosion resistance than the component material to a corrosive attack with hydrogen ions.

14. Multi-mirror array according to any of the preceding claims, **characterized in that** the reflection coating (REF) has a high reflectivity for EUV radiation, with the result that the multi-mirror array is designed as an EUV multi-mirror array.

15. Illumination system (2) for a UV apparatus (1), the illumination system (2) being designed to receive UV radiation from a UV radiation source (3) and to shape illumination radiation from at least a portion of the received UV radiation during the operation of the UV apparatus, the illumination radiation being directed at an illumination field in an exit plane (6) of the illumination system, **characterized in that** the illumination system (2) comprises at least one multi-mirror array (MMA, 20, 22) according to any of the preceding claims.

## Revendications

1. Ensemble à miroirs multiples (20, 22, MMA) comprenant :
une structure de support (TS),
une pluralité d'unités de miroir (MU), qui sont disposées côte à côte sur la structure de support selon un agencement en grille :
chaque unité de miroir (MU) comportant un élément de base (BE) et un élément de miroir (ME) monté de manière mobile individuellement par rapport à l'élément de base (BE), lequel comporte un substrat de miroir (SUB) qui supporte un revêtement réfléchissant (REF) pour former une surface de miroir (MS) réfléchissant le rayonnement ultraviolet sur une surface avant opposée à l'élément de base (BE), comporte une surface arrière tournée vers l'élément de base et, sur sa périphérie, des surfaces latérales ;
l'agencement des éléments de miroir présentant une conception telle qu'un déplacement relatif des éléments de miroir les uns par rapport aux autres s'effectue dans une plage de déplacement prévue des éléments de miroir sans collision mutuelle,
les surfaces de miroir (MS) étant disposées côte à côte de manière à remplir sensiblement la surface et un espace (SP) délimité par des surfaces latérales (SF1, SF2) des substrats de miroir (SUB) se jouxtant demeurant entre des éléments de miroir directement adjacents pour assurer un déplacement relatif sans collision des éléments de miroir adjacents, et
des composants fonctionnels de l'unité de miroir étant disposés pour chaque unité de miroir (MU) dans un espace intermédiaire (ZR) entre l'élément de base (BE) et l'élément de miroir (ME) ;
**caractérisé en ce que** les surfaces latérales (SF1, SF2) des substrats de miroir (SUB1, SUB2) sont orientées chacune au moins par sections de manière inclinée selon un angle différent de 90°par rapport à la surface de miroir (MS) associée.

2. Ensemble à miroirs multiples selon la revendication 1, **caractérisé en ce que** sont disposés, dans l'espace intermédiaire (ZR) entre l'élément de base (BE) et l'élément de miroir (ME), des composants fonctionnels de l'unité de miroir sous la forme de composants d'un système de suspension (SUS) pour le montage mobile de l'élément de miroir (ME) sur l'élément de base (BE) ainsi que des composants d'un système d'actionnement (AKT) pour générer des déplacements de l'élément de miroir (ME) par rapport à l'élément de base (BE) en réponse à la réception de signaux de commande, au moins l'élément de base (BE), le système de suspension (SUS) et le système d'actionnement (AKT) étant de préférence formés comme une structure MEMS en silicium, Si, ou en un composé de silicium, et/ou **caractérisé en ce que** le revêtement réfléchissant (REF) constitue une surface de miroir (MS) réfléchissant le rayonnement EUV et/ou le rayonnement DUV.

3. Ensemble à miroirs multiples selon la revendication 1 ou 2, **caractérisé en ce que** les surfaces latérales des substrats de miroir (SUB) de substrats de miroir (SUB1, SUB2) directement adjacents sont chacune formées et orientées de telle manière que l'espace (SP) formé entre des substrats de miroir directement adjacents présente une largeur d'espace (SB), qui augmente depuis la surface avant (VF), pourvue du revêtement réfléchissant (REF), d'un élément de miroir en direction de l'élément de base (BE) et/ou que la surface avant (VF), pourvue du revêtement réfléchissant (REF), d'un élément de miroir comporte une aire surfacique plus grande qu'une surface entourée par le bord extérieur de la surface arrière, s'étendant de préférence parallèlement à la surface avant, le bord extérieur de la surface arrière étant décalé vers l'intérieur par rapport à un bord extérieur de la surface avant sur toutes les positions périphériques d'un décalage latéral (LV), de préférence le substrat de miroir présentant une épaisseur mesurée entre la surface avant et la surface arrière et le décalage (LV) étant d'au moins 3 %, de préférence d'au moins 5 % de l'épaisseur et/ou au maximum de 10 % de l'épaisseur.

4. Ensemble à miroirs multiples selon l'une des revendications précédentes, **caractérisé en ce qu'**un angle (W) formé sur la transition entre la surface avant (VF) et la surface latérale (SF) qui jouxte se situe dans la plage de 80° à 89°, en particulier dans la plage de 84° à 88°.

5. Ensemble à miroirs multiples selon l'une des revendications précédentes, **caractérisé en ce que** les substrats de miroir (SUB1, SUB2) présentent une forme de section transversale sensiblement trapézoïdale avec une base plus large sur le côté de la surface avant (VF) dans une coupe réalisée entre des surfaces latérales opposées.

6. Ensemble à miroirs multiples selon l'une des revendications précédentes, **caractérisé en ce que** les surfaces latérales (SF) présentent une rugosité de surface, qui est supérieure d'au moins un ordre de grandeur à la rugosité de surface de la face avant (VF) pourvue du revêtement réfléchissant (REF), la rugosité de surface des faces latérales étant de préférence d'au moins 100 nm RMS.

7. Ensemble à miroirs multiples selon la revendication 1 ou 2, **caractérisé en ce que** les zones de bord de substrats de miroir (SUB) de substrats de miroir (SUB1, SUB2) directement adjacents sont orientées chacune de manière inclinée selon un angle différent de 90° par rapport à la surface de miroir (MS) associée de telle manière que les surfaces latérales obliques délimitent un espace (SP) orienté à l'oblique par rapport aux surfaces de miroir (MS), l'espace (SP) jouxtant les surfaces de miroir (MS1, MS2) comportant une première ouverture d'espace (SO1) avec une première largeur d'espace et l'espace jouxtant des côtés arrière des substrats de miroir, une deuxième ouverture d'espace (SO2) avec une deuxième largeur d'espace, la première et la deuxième ouverture d'espace comportant un décalage latéral (LV) du fait de l'orientation oblique de l'espace (SP), de telle sorte qu'une largeur d'espace efficace pour un passage de rayonnement direct est inférieure à la première largeur d'espace (SB1) et/ou à la deuxième largeur d'espace (SB2), le décalage latéral (LV) étant, de préférence, au moins aussi grand que le maximum de la première largeur d'espace (SB1) et de la deuxième largeur d'espace (SB2).

8. Ensemble à miroirs multiples selon l'une des revendications précédentes, **caractérisé en ce que** les substrats de miroir comportent, dans une coupe réalisée entre des surfaces latérales opposées, une forme de section transversale sensiblement trapézoïdale, des éléments de miroir se suivant en une rangée comportant de préférence en alternance une forme de section transversale trapézoïdale inversée de telle sorte que l'orientation des espaces obliques intercalés varie alternativement d'un espace à l'autre.

9. Ensemble à miroirs multiples selon l'une des revendications 2 à 8, **caractérisé par** un dispositif de réglage en hauteur (HVE) pouvant être commandé pour le réglage en hauteur réversible et continu d'éléments de miroir (ME) individuels par rapport à des éléments de miroir (ME) adjacents en réponse à des signaux de commande, les éléments de base (BE) étant de préférence réglables en hauteur individuellement par rapport à la structure de support, en particulier au moyen d'une couche piézoélectrique à épaisseur variable entre l'élément de support et l'élément de base, et/ou le système d'actionnement étant conçu pour générer un déplacement d'un élément de miroir (ME) selon deux degrés de liberté en rotation et un degré de liberté en translation, le degré de liberté en translation correspondant à un déplacement de l'élément de miroir (ME) le long d'un axe de translation, qui est perpendiculaire ou oblique par rapport à des axes de rotation des degrés de liberté en rotation, une commande du dispositif de réglage de hauteur (HVE) étant de préférence configurée de telle manière qu'un réglage de hauteur d'un élément de miroir peut être généré en fonction de positions de basculement d'éléments de miroir adjacents.

10. Ensemble à miroirs multiples selon l'une des revendications précédentes, **caractérisé par** des éléments piégeurs de rayonnement (TRP), qui comportent une surface d'impact de rayonnement (AF), laquelle est disposée sur le côté arrière des substrats de miroir (SUB) opposé aux surfaces de miroir dans la zone des espaces (SP), les éléments piégeurs de rayonnement (TRP) étant de préférence constitués au moins dans la zone de la surface d'impact de rayonnement (AF) d'un matériau fonctionnel (FM), qui présente au moins une des caractéristiques suivantes :
le matériau fonctionnel (FM) est un matériau absorbant ayant un effet absorbant le rayonnement EUV ; le matériau fonctionnel (FM) est un catalyseur de recombinaison qui augmente une probabilité de recombinaison des ions hydrogène au contact des ions hydrogène.
le matériau fonctionnel (FM) est choisi dans le groupe : ruthénium, Ru, platine, Pt, rhénium, Re, rhodium, Rh, iridium, Ir, molybdène, Mo, nickel, Ni, et fer, Fe,
de préférence les éléments piégeurs de rayonnement (TRP) étant réglables par sections en hauteur, un réglage en hauteur de l'élément piégeur de rayonnement (TRP) respectif pouvant être généré en fonction de positions de basculement et/ou de positions en hauteur d'éléments de miroir (ME) adjacents.

11. Ensemble à miroirs multiples selon l'une des revendications précédentes, **caractérisé en ce qu'**est prévue au moins une membrane de protection (MEM), qui comporte une section de recouvrement d'espace (AA), qui surmonte un espace (SP) formé entre des substrats de miroir (SUB1, SUB2) directement adjacents et entre en contact avec les substrats de miroir délimitant l'espace, en particulier qui est fixée sur les substrats de miroir (SUB1, SUB2), la membrane de protection (MEM3) dans la zone de la section de recouvrement d'espace (AA) comportant de préférence un matériau absorbant ayant un effet absorbant le rayonnement EUV, le matériau absorbant étant de préférence choisi dans le groupe : ruthénium, Ru, platine, Pt, rhénium, Re, rhodium, Rh, iridium, Ir, molybdène, Mo, nickel, Ni, et fer, Fe.

12. Ensemble à miroirs multiples selon la revendication 11, **caractérisé en ce que** la membrane de protection (MEM) est disposée sur le côté avant des substrats de miroir (SUB1, SUB2) selon un agencement en couches à couches multiples entre les substrats de miroir (SUB1, SUB2) et le revêtement réfléchissant (REF) et/ou qu'au moins une des caractéristiques suivantes est fournie :
une membrane de protection (MEM4) est disposée sur le côté arrière des substrats de miroir (SUB1, SUB2) ;
une membrane de protection (MEM5) est disposée entre le côté arrière du substrat de miroir (SUB) et un côté arrière de l'élément piégeur de rayonnement (TRP) ;
un réglage en hauteur dépendant de la position de basculement de l'élément piégeur de rayonnement (TRP) par la tension de couche de la membrane de protection (MEM5) entre l'unité de miroir (MU) et l'élément piégeur de rayonnement (TRP).

13. Ensemble à miroirs multiples selon l'une des revendications précédentes, **caractérisé par** une structure de protection contre la gravure sous la forme d'une couche de protection contre la gravure (SS), qui est appliquée dans une zone exposée à une attaque par gravure sur un composant de l'unité de miroir constitué d'un matériau de composant, la couche de protection contre la gravure comportant au moins un matériau de couche de protection, qui présente, vis-à-vis d'une attaque par gravure par des ions hydrogène, une résistance à la gravure supérieure à celle du matériau de composant.

14. Ensemble à miroirs multiples selon l'une des revendications précédentes, **caractérisé en ce que** le revêtement réfléchissant (REF) pour le rayonnement EUV présente un degré de réflexion élevé, de telle sorte que l'ensemble à miroirs multiples est conçu comme un ensemble à miroirs multiples EUV.

15. Système d'éclairage (2) pour une installation UV (1), le système d'éclairage (2) étant conçu pour recevoir un rayonnement UV d'une source de rayonnement UV (3) lors du fonctionnement de l'installation UV et pour former un rayonnement d'éclairage à partir d'au moins une partie du rayonnement UV reçu, qui est dirigé dans un champ d'éclairage dans un plan de sortie (6) du système d'éclairage, **caractérisé en ce que** le système d'éclairage (2) comporte au moins un ensemble à miroirs multiples (MMA, 20, 22) selon l'une des revendications précédentes.
